(19) Europäisches Patentamt
European Patent Office
Office européen des brevets

(11) EP 4 642 201 A1

(12) **EUROPEAN PATENT APPLICATION**
published in accordance with Art. 153(4) EPC

(43) Date of publication:
**29.10.2025 Bulletin 2025/44**

(21) Application number: **23907780.3**

(22) Date of filing: **21.12.2023**

(51) International Patent Classification (IPC):
***H10K 50/86*** *(2023.01)* ***H10K 50/858*** *(2023.01)*
***G02B 5/00*** *(2006.01)* ***G02B 5/22*** *(2006.01)*

(52) Cooperative Patent Classification (CPC):
**G02B 5/00; G02B 5/22; H10K 50/858; H10K 50/86; H10K 59/80**

(86) International application number:
**PCT/KR2023/021188**

(87) International publication number:
**WO 2024/136497 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.12.2022 KR 20220180437**

(71) Applicant: **LG CHEM, LTD.**
**Seoul 07336 (KR)**

(72) Inventors:
- **KWON, Do Hyung**
**Daejeon 34122 (KR)**
- **KIM, Jun Hyeong**
**Daejeon 34122 (KR)**
- **CHANG, Woo Hyuck**
**Daejeon 34122 (KR)**
- **KANG, Hae Goo**
**Daejeon 34122 (KR)**
- **HAN, Byeong Heui**
**Daejeon 34122 (KR)**

(74) Representative: **Goddar, Heinz J.**
**Boehmert & Boehmert Anwaltspartnerschaft mbB**
**Pettenkoferstrasse 22**
**80336 München (DE)**

(54) **LIGHT CONTROL FILM**

(57) The present specification discloses a light control film, and a display device to which the light control film is applied. The light control film enables precise control of a light-outgoing angle, can secure high transmittance, high luminance, and excellent resolution within the light-outgoing angle, and block unnecessary light capable of causing defects such as so-called ghosts or moire, as it is applied to a display device. Even when the light control film is applied to an OLED display, the light control film exhibits the above performance, and simultaneously prevents defects, such as stripes, that can be recognized by an observer from occurring. The present specification also discloses a display device to which the light control film is applied.

[Figure 1]

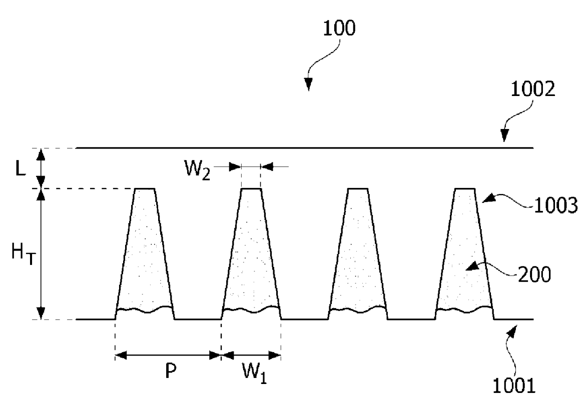


EP 4 642 201 A1

## Description

[Technical Field]

This application claims the benefit of priority based on Korean Patent Application No. 10-2022-0180437 dated December 21, 2022, the disclosure of which is incorporated herein by reference in its entirety.

The present specification discloses a light control film, and a display device to which the light control film is applied, and the like.

[Background Art]

A light control film is also called a light collimating film. The light control film is configured to be capable of controlling light transmittance and controlling a light-outgoing direction in a display device, and the like.

As the display device, an LCD (Liquid Crystal Display) or an OLED (Organic Light Emitting Diode), and the like are known. Such a display device is generally designed to ensure a wide viewing angle. However, for example, when the display device is viewed in a public place, it may be required that the screen of the display device is not exposed to the surrounding people. Also, in the case of a vehicle display, the breadth and narrowness of the viewing angle and/or the light-outgoing direction of the display, and the like need to be adjusted depending on the location of the display, considering the influence on a driver and the convenience of passengers, and the like.

The light control film can be used, in such an application, for controlling the light-outgoing direction or angle, and controlling light transmittance.

Various types of light control films are known. These films typically comprise a light-transmissive film having a plurality of parallel grooves, and a material absorbing light present in the grooves (for example, the viewing angle control sheet of Patent Document 1).

For these light control films, precise control of the light-outgoing angle, securing of high transmittance, high luminance, and excellent resolution within the light-outgoing angle, blocking of unnecessary light causing defects called so-called ghosts or moire, and the like are required.

In addition to the above characteristics generally required for light control films, additional characteristics may be required while the types of displays are diversified.

Most of the light control films known to date are designed for LCDs.

In the case of the LCD, the light control film is disposed between a liquid crystal panel and a backlight. In this way, in the LCD, the light control film is disposed relatively inside the screen on which the image is projected, and is disposed adjacent to the backlight generating strong light. Also, in addition to the light control film, a diffusion film or a prism film, and the like exist between the liquid crystal panel and the backlight.

Therefore, in the case of the LCD, even when the light control film is applied, an observer does not recognize defects such as unnecessary stripes caused by the light control film.

In the case of an OLED (Organic Light Emitting Diode) display, a polarizing layer is usually present on an OLED panel, where the side on which the polarizing layer exists becomes the side on which the screen is displayed.

When the light control film is applied to the OLED display, it is usually disposed between the OLED panel and the polarizing layer, or on the side surface of the polarizing layer opposite to the OLED panel.

In this way, in the OLED display, the light control film is located relatively close to the observer. Also, in the case of the OLED, it is a self-luminous element, where there is no element emitting strong light like the backlight of the LCD. Therefore, when the light control film is applied to the OLED display, the observer can easily recognize defects such as unnecessary stripes caused by the light control film.

[Prior Art Documents]

[Patent Documents]

(Patent Document 1) Japanese Laid-Open Patent Publication No. 2006-171701

[Disclosure]

[Technical Problem]

The present specification discloses a light control film, and a display device to which the light control film is applied. The present specification is intended to disclose a light control film which can control a light-outgoing angle, and secure high transmittance, high luminance, and excellent resolution within the light-outgoing angle, and does not cause

defects such as so-called ghosts or moire, in a display device.

The present specification is intended to disclose contents that even when the light control film is applied to an OLED display, the light control film exhibits the above performance, and simultaneously prevents defects, such as stripes, that can be recognized by an observer from occurring.

The present specification discloses a display device to which the light control film is applied.

[Technical Solution]

Among the physical properties mentioned in this specification, when the measurement temperature affects the relevant physical property, the physical property is measured at room temperature, unless otherwise specified.

The term room temperature is a natural temperature without warming or cooling, which may mean, for example, any temperature in a range of about 10°C to 30°C, or a temperature of about 23°C or about 25°C or so.

In this specification, the unit of temperature is °C, unless otherwise specified.

Among the terms used in defining angles in this specification, the terms vertical, parallel, orthogonal, and horizontal, as well as the numerical value of any specific angle, should be interpreted considering manufacturing errors, and the like. Therefore, the term and the numerical value of the angle mean substantially vertical, parallel, orthogonal, or horizontal, and the numerical value of the angle in a range without impairing the intended effect. The ranges of the vertical, parallel, orthogonal, or horizontal, and the numerical value include errors such as manufacturing errors or variations. For example, the respective cases may include an error within about ±3 degrees, an error within about ±2 degrees, an error within about ±1 degree, an error within about ±0.8 degrees, an error within about ±0.6 degrees, or an error within about ±0.4 degrees.

Unless otherwise specified, the angle formed by any two directions or sides, which is mentioned herein, may be a small angle of angles measured in clockwise and counterclockwise directions from any one direction or side of the two directions or sides. Thus, unless otherwise specified, the angles mentioned herein are positive numbers. To display the measurement direction between the angles measured in the clockwise direction or the counterclockwise direction, if necessary, the angle measured in the clockwise direction may be represented as a positive number, and the angle measured in the counterclockwise direction may be represented as a negative number.

Unless otherwise specified herein, the unit of angle is degrees.

Unless otherwise specified herein, a reference wavelength of a refractive index is about 589 nm.

The present specification discloses a light control film.

The light control film comprises a main body in which grooves are formed, and a filling material present in the grooves of the main body.

Figure 1 is an exemplary cross-sectional diagram of a light control film (100) comprising the main body and a filling material (200).

As shown in Figure 1, the main body of the light control film (100) has a first surface (1001) and a second surface (1002) facing the first surface (1001). When the light control film is applied to a display device, one of the first and second surfaces (1001, 1002) may be a light input surface and the other surface may be a light output surface. The first and second surfaces (1001, 1002) may be formed substantially parallel to each other. For example, in the cross section of the light control film, the angle formed by the first surface (1001) and the second surface (1002) may be within a range of about 0 degrees to 10 degrees.

As shown in Figure 1, a plurality of grooves (1003) extending in a direction toward the second surface (1002) are formed on the first surface (1001) of the main body of the light control film (100).

A filling material (200) is present inside such grooves (1003), and the filling material includes a light absorbing material. With such a structure, the main body, and the filling material (200) filled in the grooves (1003) may form transmission regions and absorption regions that are alternately repeated along the direction where the first or second surface (1001 or 1002) is formed in the cross section.

For example, the region where no filling material (200) is present in the first and second surfaces, or the main body of the light control film may form the transmission region, and the region where the filling material (200) is present may form the absorption region.

The absorption region may play a role in absorbing or blocking light which is incident to deviate from the intended light-outgoing angle among light incident on the light input surface, or changing the direction of the light through total reflection, and the like.

In one example, as shown in Figure 2, when the first surface (1001) of the main body in the light control film (100) is observed in the normal direction of the first surface (1001), the groove (1003) may be formed to indicate a straight-line shape.

In the light control film, the grooves (1003) are filled with the filling material (200) at an excellent filling rate, and each of the plurality of grooves (1003) is uniformly filled with the filling material.

The existing light control films have been also constructed by filling the grooves of the groove-formed main body

with a filling material containing a light-absorbing material, but no attention has been paid to the specific filling rate if the grooves have been filled with the filling material above a certain level, and the uniformity of the filling material filled in each of the plurality of grooves has hardly considered.

Since the existing light control films have been designed mainly for LCDs, this reason is because even if the filling rate of the filling material is lowered or there is some degree of non-uniformity, the resulting appearance defects are not recognized by an observer.

However, when the light control film is applied to OLED displays, and the like, the filling rate and filling uniformity of the filling material are importantly linked to whether an observer can recognize defects caused by the light control film.

In the light control film, the average and standard deviation of the depth of the region where the filling material is unfilled in the plurality of grooves filled with the filling material may be controlled.

The depth of the region where the filling material is unfilled will be described with reference to Figure 3. Figure 3 is a diagram showing an enlarged cross section of one groove (1003) of the plurality of grooves (1003) in the light control film (100) of Figure 1.

As shown in Figure 3, the depth of the region where the filling material (200) is unfilled is the shortest distance (D1, D2, etc. in Figure 3) from the first surface (1001) of the main body to the filling material (200). The first surface that serves as the standard for the depth is a virtual surface or line (1001l in Figure 3) connecting the first surfaces (1001) existing on both sides of the portion where the groove (1003) is formed.

As shown in Figure 3, when there are two or more shortest distances, the shortest distance in calculating the average depth of the region where the filling material is unfilled is the longest distance (in the case of Figure 3, D2) among the two or more shortest distances. By obtaining the shortest distance for each of the plurality of grooves formed in the main body, and making the arithmetic average thereof, it is possible to obtain the average depth of the region where the filling material is unfilled.

The lower limit of the average depth of the region where the filling material is unfilled in the plurality of grooves may be 0 μm, 0.5 μm, 1 μm, 1.5 μm, or 2 μm. The upper limit of the average may be 3 μm, 2.9 μm, 2.8 μm, 2.7 μm, 2.6 μm, 2.5 μm, 2.4 μm, 2.3 μm, or 2.2 μm or so. The average may also be adjusted within a range of less than or equal to, or less than any one of the above-described upper limits; or within a range of less than or equal to, or less than any one of the above-described upper limits, while being more than or equal to, or more than any one of the above-described lower limits.

The upper limit of the standard deviation of the depth of the region where the filling material is unfilled in the plurality of grooves may be 0.2, 0.19, 0.18, 0.17, or 0.16 or so, and the lower limit of the standard deviation may also be 0, 0.01, 0.02, 0.03, 0.04, 0.05, 0.06, 0.07, 0.08, 0.09, 0.1, 0.11, 0.12, 0.13, 0.14, or 0.15 or so. The standard deviation may also be adjusted within a range of less than or equal to, or less than any one of the above-described upper limits; or within a range of less than or equal to, or less than any one of the above-described upper limits, while being more than or equal to, or more than any one of the above-described lower limits. The unit of the standard deviation may be μm.

In the light control film, the filling rate and filling uniformity of the filling material into the grooves are controlled as described above. Therefore, the light control film does not cause appearance defects due to the light control film even when it is applied to a device, such as an OLED display, in which the light control film is disposed adjacent to the observer.

To achieve the filling rate and filling uniformity, at least one, or two or more of a tensile strength of the main body, an elastic restoring force of the main body, and a shape of the groove may be controlled, as described below.

The shape of the groove may be controlled variously to achieve desired light control performance and/or filling characteristics.

As shown in Figure 4, in the cross section of the main body of the light control film (100), the groove may have a first side (10031) extending from the first surface (1001) of the main body toward the second surface (1002) of the main body, and a second side (10032) facing the first side (10031) and extending toward the second surface (1002).

As described above, when the groove has a straight-line shape upon observing the first surface (1001) in the normal direction of the first surface (1001) of the main body, the cross section may be a cross section which is perpendicular to the straight-line shape of the groove and in a direction parallel to the normal direction of the first surface (1001).

As shown in Figure 4, the groove may form a first angle (θ1 in Figure 4) formed by the first side (10031) with the normal direction of the first surface (1001), and a second angle (θ2 in Figure 4) formed by the second side (10032) with the normal direction of the first surface (1001).

The first and second angles may be the same as or different from each other.

For example, the lower limit of the first angle may be 0 degrees, 0.5 degrees, 1 degree, 1.5 degrees, 2 degrees, 2.5 degrees, 3 degrees, 3.5 degrees, 4 degrees, 4.5 degrees, 5 degrees, 5.5 degrees, 6 degrees, 6.5 degrees, 7 degrees, 7.5 degrees, 8 degrees, 8.5 degrees, 9 degrees, or 9.5 degrees or so, and the upper limit may also be 10 degrees, 9.5 degrees, 9 degrees, 8.5 degrees, 8 degrees, 7.5 degrees, 7 degrees, 6.5 degrees, 6 degrees, 5.5 degrees, 5 degrees, 4.5 degrees, 4 degrees, 3.5 degrees, 3 degrees, 2.5 degrees, 2 degrees, 1.5 degrees, 1 degree, or 0.5 degrees or so. The angle may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less

than any one of the above-described upper limits.

For example, the lower limit of the second angle may be 0 degrees, 0.5 degrees, 1 degree, 1.5 degrees, 2 degrees, 2.5 degrees, 3 degrees, 3.5 degrees, 4 degrees, 4.5 degrees, 5 degrees, 5.5 degrees, 6 degrees, 6.5 degrees, 7 degrees, 7.5 degrees, 8 degrees, 8.5 degrees, 9 degrees, or 9.5 degrees or so, and the upper limit may also be 10 degrees, 9.5 degrees, 9 degrees, 8.5 degrees, 8 degrees, 7.5 degrees, 7 degrees, 6.5 degrees, 6 degrees, 5.5 degrees, 5 degrees, 4.5 degrees, 4 degrees, 3.5 degrees, 3 degrees, 2.5 degrees, 2 degrees, 1.5 degrees, 1 degree, or 0.5 degrees or so. The angle may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The first and second angles may be adjusted in consideration of desired light control performance and/or filling characteristics, and the like.

The first and second angles may be the same as or different from each other.

When the first and second angles are different from each other, the first angle may be 2 degrees or more, and the second angle may be 2 degrees or less. **In** the above case, when the first angle is 2 degrees, the second angle is less than 2 degrees; and when the second angle is 2 degrees, the first angle is more than 2 degrees.

When the first and second angles are different from each other, the lower limit of the first angle may be 2 degrees, 2.5 degrees, 3 degrees, 3.5 degrees, or 4 degrees or so, and the upper limit thereof may be 4 degrees, 3.5 degrees, 3 degrees, 2.5 degrees, or 2 degrees. The first angle may also be within a range of more than or equal to, or more than any one of the above-described lower limits; or within a range of less than or equal to, or less than any one of the above-described upper limits, while being within a range of more than or equal to, or more than any one of the above-described lower limits.

When the first and second angles are different from each other, the upper limit of the second angle may be 2 degrees, 1.5 degrees, 1 degree, or 0.5 degrees or so, and the lower limit thereof may be 0 degrees, 0.5 degrees, 1 degree, 1.5 degrees, or 2 degrees or so. The second angle may also be within a range of less than or equal to, or less than any one of the above-described upper limits; or within a range of less than or equal to, or less than any one of the above-described upper limits, while being more than or equal to, or more than any one of the above-described lower limits.

In one example, the angle formed by the first or second side of the groove with the normal direction of the first surface may be two or more.

Figure 5 is an example showing such a shape. Figure 5 shows a case where both the first side (10031) and the second side (10032) form two angles with the normal direction of the first surface (1001), without being limited thereto. That is, for example, in the light control film, only one of the first and second sides may form two angles with the normal direction, and the other side may form only one angle, and one or more sides may also form three or more angles with the normal direction.

As exemplarily shown in Figure 5, when the first side (10031) or the second side (10032) forms two or more angles with the normal direction, the first side (10031) or the second side (10032) may include a side A (10031A, 10032A) forming an angle A (θA in Figure 5) with the normal direction of the first surface (1001), and a side B (10031B, 10032B) forming an angle B (θB in Figure 5) different from the angle A.

When the side B (10031B, 10032B) is located closer to the second surface (1002) of the main body compared to the side A (10031A, 10032A), the angle A (θA in Figure 5) may be larger or smaller than the angle B (θB in Figure 5).

When the angle A is smaller than the angle B, the angle A (θA in Figure 5) may be 2 degrees or less, and the angle B (θB in Figure 5) may be 2 degrees or more. Here, when the angle A (θA in Figure 5) is 2 degrees, the angle B (θB in Figure 5) may be more than 2 degrees; and when the angle B (θB in Figure 5) is 2 degrees, the angle A (θA in Figure 5) may be less than 2 degrees.

Here, the lower limit of the angle B (θB in Figure 5) may be 2 degrees, 2.5 degrees, 3 degrees, 3.5 degrees, or 4 degrees or so, and the upper limit thereof may be 4 degrees, 3.5 degrees, 3 degrees, 2.5 degrees, or 2 degrees or so. The angle B may also be within a range of more than or equal to, or more than any one of the above-described lower limits; or within a range of less than or equal to, or less than any one of the above-described upper limits, while being within a range of more than or equal to, or more than any one of the above-described lower limits.

Here, the upper limit of the angle A (θA in Figure 5) may be 2 degrees, 1.5 degrees, 1 degree, or 0.5 degrees or so, and the lower limit thereof may be 0 degrees, 0.5 degrees, 1 degree, 1.5 degrees, or 2 degrees or so. The angle A may also be within a range of less than or equal to, or less than any one of the above-described upper limits; or within a range of less than or equal to, or less than any one of the above-described upper limits, while being more than or equal to, or more than any one of the above-described lower limits.

When the angle A is larger than the angle B, the angle B (θB in Figure 5) may be 2 degrees or less, and the angle A (θA in Figure 5) may be 2 degrees or more. When the angle B (θB in Figure 5) is 2 degrees, the angle A (θA in Figure 5) may be more than 2 degrees; and when the angle A (θA in Figure 5) is 2 degrees, the angle B (θB in Figure 5) may be less than 2 degrees.

Here, the lower limit of the angle A (θA in Figure 5) may be 2 degrees, 2.5 degrees, 3 degrees, 3.5 degrees, or 4 degrees or so, and the upper limit thereof may be 4 degrees, 3.5 degrees, 3 degrees, 2.5 degrees, or 2 degrees or so. The angle A may also be within a range of more than or equal to, or more than any one of the above-described lower limits; or within a range of less than or equal to, or less than any one of the above-described upper limits, while being within a range of more than or equal to, or more than any one of the above-described lower limits.

Here, the upper limit of the angle B (θB in Figure 5) may be 2 degrees, 1.5 degrees, 1 degree, or 0.5 degrees or so, and the lower limit thereof may be 0 degrees, 0.5 degrees, 1 degree, 1.5 degrees, or 2 degrees or so. The angle B may also be within a range of less than or equal to, or less than any one of the above-described upper limits; or within a range of less than or equal to, or less than any one of the above-described upper limits, while being more than or equal to, or more than any one of the above-described lower limits.

As described above, when the first side or the second side of the groove includes the side A and the side B, R of Equation 1 below may be within a predetermined range.

[Equation 1]

$$R = (100 \times L_B \times \cos\theta_B)/(L_A \times \cos\theta_A + L_B \times \cos\theta_B)$$

In Equation 1, $L_A$ and $L_B$ are the lengths of the side A and the side B, respectively, and $\theta_A$ and $\theta_B$ are the angle A and the angle B, respectively.

In Equation 1, the units of $L_A$ and $L_B$ are not limited if the same units are applied to each other.

The lower limit of R in Equation 1 may be 5%, 10%, 15%, 20%, 25%, 30%, 35%, or 40% or so, and the upper limit thereof may be 40%, 35%, 30%, 25%, 20%, 15%, 10%, or 5% or so. R in Equation 1 may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The groove with such a shape may be suitable for securing desired light control performance and filling characteristics.

To secure desired filling characteristics, and the like, the shape of the surface of the main body, particularly the shape of the first surface between grooves, may be controlled.

For example, as shown in Figure 6, in the cross section of the main body, the first surface (1001) between the grooves may comprise an opposite side (10); a first inclined side (20), one end of which is connected to each of both ends of the opposite side (10), forming an angle θ11 with the opposite side (10); and a second inclined side (30), one end of which is connected to the end of the first inclined side (20) which is not connected to the opposite side (10), forming an angle θ21 with the opposite side (10). Here, the opposite side (10) may be, for example, the first surface (1001) that is substantially horizontal to the second surface (1002) of the main body.

By forming the above structure, it is possible to improve filling and takeoff properties of the filling material during the manufacturing process of the light control film, and accordingly, it is possible to efficiently secure the above-described filling rate and filling uniformity, and in addition, it is also possible to stably maintain surface characteristics of the light control film.

As described above, when the groove has a straight-line shape upon observing the first surface (1001) in the normal direction of the first surface (1001) of the main body, the cross section may be a cross section which is perpendicular to the straight-line shape of the groove and in a direction parallel to the normal direction of the first surface (1001).

The opposite side (10) may form an angle of 0 degrees to 10 degrees, 0 degrees to 9 degrees, 0 degrees to 8 degrees, 0 degrees to 7 degrees, 0 degrees to 6 degrees, 0 degrees to 5 degrees, 0 degrees to 4 degrees, 0 degrees to 3 degrees, 0 degrees to 2 degrees, 0 degrees to 1 degree, or substantially 0 degrees with the side formed by the second surface (1002) in the cross section.

The angle θ11 and the angle θ21 may be different from each other.

In one example, the lower limit of the angle θ11 above may be 0.5 degrees, 1 degree, 1.5 degrees, 2 degrees, 2.5 degrees, 3 degrees, 3.5 degrees, 4 degrees, 4.5 degrees, 5 degrees, 5.5 degrees, 6 degrees, 6.5 degrees, 7 degrees, 7.5 degrees, 8 degrees, 8.5 degrees, 9 degrees, 9.5 degrees, 10 degrees, 10.5 degrees, or 11 degrees or so, and the upper limit thereof may also be 11 degrees, 10.5 degrees, 10 degrees, 9.5 degrees, 9 degrees, 8.5 degrees, 8 degrees, 7.5 degrees, 7 degrees, 6.5 degrees, 6 degrees, 5.5 degrees, 5 degrees, 4.5 degrees, 4 degrees, 3.5 degrees, 3 degrees, or 2.5 degrees or so. The angle θ11 may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

Here, the lower limit of the ratio θ21/θ11 of the angles θ21 and θ11 may be 5, 6, 7, 8, 9, 10, 11, 12, 13, 14, 15, 16, 17, 18, 19, 20, 21, 22, 23, 24, 25, 26, 27, 28, or 29 or so, and the upper limit thereof may be 100, 95, 90, 85, 80, 75, 70, 65, 60, 55, 50, 45, 40, 35, 30, 25, 20, 19, 18, 17, 16, 15, 14, 13, 12, 11, 10, or 9. The ratio θ21/θ11 may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In the above structure, H according to Equation 2 below may be adjusted.

[Equation 2]

$$H = L1 \times \sin\theta 11$$

In Equation 2, L1 is the length of the first inclined side, and θ11 is the angle formed by the opposite side and the first inclined side.

The upper limit of H above may be 3 μm, 2.5 μm, 2 μm, 1.5 μm, 1 μm, or 0.5 μm or so. The lower limit of H above may also be 0.01 μm, 0.05 μm, 0.1 μm, 0.2 μm, 0.3 μm, 0.4 μm, 0.5 μm, 1 μm, 1.5 μm, 2 μm, or 2.5 μm or so. The H may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In the above structure, the lower limit of the ratio $H_T/H$ of the total depth ($H_T$ in Figure 1) of the groove to H of Equation 2 above may be 10, 15, 20, 25, 30, 35, 40, 45, 50, 55, 60, 65, 70, 75, 80, 85, 90, 95, 100, 110, 120, 130, 140, 150, or 155 or so. The upper limit of the ratio $H_T/H$ may be 1,000, 950, 900, 850, 800, 750, 700, 650, 600, 550, 500, 450, 400, 350, 300, 250, 200, 190, 180, 170, 160, 150, 140, 130, 120, 110, 100, 95, 90, 85, 80, 75, 70, 65, 60, 55, 50, 45, or 40 or so. The ratio $H_T/H$ may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In the above structure, if the length of the opposite side is T, the T may be adjusted so that the value K of Equation 3 below is within a predetermined range.

[Equation 3]

$$K = T/(T+2\times\cos\theta 11\times L1)$$

In Equation 3, T is the length of the opposite side, L1 is the length of the first inclined side, and θ11 is the angle formed by the opposite side and the first inclined side.

In Equation 3, the units of T and L1 are not limited if the same units are applied to each other.

The lower limit of K in Equation 3 may be 0.01, 0.05, 0.1, 0.15, or 0.2 or so, and the upper limit thereof may be 2, 1.5, 1, 0.9, 0.8, 0.7, 0.6, 0.5, 0.4, 0.3, or 0.25 or so. The K may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

By applying such a structure, it is possible to achieve the desired filling characteristics more efficiently.

The range of the depth ($H_T$ in Figure 1) of the groove formed in the main body is not particularly limited, which may be adjusted in consideration of the desired performance. The lower limit of the depth may be, for example, 50 μm, 55 μm, 60 μm, 65 μm, 70 μm, 75 μm, 80 μm, 85 μm, 90 μm, 95 μm, or 100 μm or so. The upper limit of the depth may also be, for example, 200 μm, 195 μm, 190 μm, 185 μm, 180 μm, 175 μm, 170 μm, 165 μm, 160 μm, 155 μm, 150 μm, 145 μm, 140 μm, 135 μm, 130 μm, 125 μm, 120 μm, 115 μm, 110 μm, 105 μm, 100 μm, 95 μm, 90 μm, 85 μm, or 80 μm or so. The depth may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. When the plurality of grooves exists and the depths of the relevant grooves are not constant, the depth of the groove may be an arithmetic average of the depths of the plurality of grooves.

The pitch of the plurality of grooves formed in the main body may also be adjusted in consideration of the desired performance. Here, the pitch is the distance from the starting point of one groove on the first surface (1001) to the starting

point of another groove adjacent to the groove, as indicated by P in Figure 1. The lower limit of the pitch may be, for example, 10 μm, 15 μm, 20 μm, 25 μm, 30 μm, 35 μm, 40 μm, 45 μm, 50 μm, 55 μm, or 60 μm or so. The upper limit of the pitch may also be, for example, 150 μm, 145 μm, 140 μm, 135 μm, 130 μm, 125 μm, 120 μm, 115 μm, 110 μm, 105 μm, 100 μm, 95 μm, 90 μm, 85 μm, 80 μm, 75 μm, 70 μm, 65 μm, 60 μm, 55 μm, 50 μm, 45 μm, or 40 μm or so. When the plurality of grooves exists and the pitches between the relevant grooves are not constant, the pitch of the groove may be an arithmetic average of the pitches of the plurality of grooves. The pitch of the groove may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The width of the groove formed in the main body may also be adjusted in consideration of the desired performance. Here, the width is the dimension of the groove identified on the first surface (1001) of the cross section of the main body, as indicated by $W_1$ in Figure 1. The lower limit of the width may be, for example, 1 μm, 2 μm, 3 μm, 4 μm, 5 μm, 6 μm, 7 μm, 8 μm, 9 μm, 10 μm, 11 μm, or 12 μm. The upper limit of the width may also be 50 μm, 45 μm, 40 μm, 35 μm, 30 μm, 25 μm, 20 μm, 15 μm, 14 μm, 13 μm, 12 μm, 11 μm, or 10 μm or so. When the plurality of grooves exists and the widths of the relevant grooves are not constant, the width of the groove may be an arithmetic average of the widths of the plurality of grooves. The width of the groove may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The difference ($P-W_1$) between the groove pitch (P) and the groove width ($W_1$) may also be adjusted in consideration of the desired performance. The lower limit of the difference ($P-W_1$) may be, for example, 5 μm, 10 μm, 15 μm, 20 μm, 25 μm, or 30 μm. The upper limit of the difference ($P-W_1$) may also be 100 μm, 95 μm, 90 μm, 85 μm, 80 μm, 75 μm, 70 μm, 65 μm, 60 μm, 55 μm, 50 μm, 45 μm, 40 μm, 35 μm, or 30 μm or so. When the differences ($P-W_1$) are not constant due to the presence of the plurality of grooves, the difference ($P-W_1$) may be an arithmetic average. The difference ($P-W_1$) may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

An aperture ratio may be controlled in the light control film.

In one example, the lower limit of the aperture ratio (aperture ratio of the transmission region) on the first surface of the main body may be 60%, 65%, 70%, 75%, or 80% or so. In another example, the upper limit of the aperture ratio (aperture ratio of the transmission region) on the first surface may be 100%, 95%, 90%, 85%, 80%, 75%, 70%, or 65% or so. The aperture ratio may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. The aperture ratio of the first surface is the ratio of the area of the transmission region formed on the first surface to the total area of the first surface, and for example, referring to Figure 1, it is the ratio of the area of the transmission region (the area of the first surface (1001) excluding the regions forming the width $W_1$ in Figure 1) formed on the first surface to the total area of the first surface (1001).

In one example, the lower limit of the aperture ratio (aperture ratio of the transmission region) on the second surface of the main body may be 60%, 65%, 70%, 75%, 80%, 85%, or 90% or so. The upper limit of the aperture ratio (aperture ratio of the transmission region) on the second surface may be less than 100%, 95% or less, 90% or less, 85% or less, or 80% or less or so. The aperture ratio may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. The aperture ratio of the second surface is the ratio of the area of the transmission region formed on the second surface to the total area of the second surface, and for example, referring to Figure 1, it is the ratio of the area of the transmission region (the area of the second surface (1002) excluding the regions forming the width $W_2$ in Figure 1) formed on the second surface to the total area of the second surface (1002).

In the main body, a ratio (O2/O1) of the aperture ratio (O2) on the second surface to the aperture ratio (O1) on the first surface may be within a predetermined range. For example, the lower limit of the ratio (O2/O1) may be 1, 1.01, 1.05, 1.1, 1.15, 1.2, 1.25, 1.3, 1.35, 1.4, or 1.45 or so, and the upper limit thereof may be 5, 4.5, 4, 3.5, 3, 2.5, 2, or 1.5 or so. The ratio O2/O1 may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The refractive index relationship between the main body (transmission region) and the filling material (absorption region) may be adjusted in consideration of the desired light control performance. At this time, the refractive index relationship may be determined considering the application to which the light control film is applied.

For example, when the refractive index of the main body (transmission region) is N1 and the refractive index of the filling material (absorption region) is N2, N1 and N2 above may satisfy a relationship of N1>N2, a relationship of N1 = N2, or a relationship of N1<N2, and may satisfy any one of the relationships depending on the applied use.

In the light control film, the upper limit of the absolute value of the difference between the refractive indices N1 and N2 may be 0.1, 0.09, 0.08, 0.07, 0.06, 0.05, 0.04, 0.03, or 0.02. The lower limit of the absolute value of the difference between the refractive indices N1 and N2 may be 0, 0.01, 0.02, 0.03, 0.04, 0.05, 0.06, 0.07, 0.08, or 0.09 or so. The absolute value of the refractive index difference may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

While the N1 and N2 satisfy the relationship of N1 > N2, the relationship of N1 = N2, or the relationship of N1 < N2, the absolute value of the refractive index difference may be within the above range.

As described above, depending on the applied use of the light control film, it is possible to satisfy a combination within any one of the three types of refractive index relationships as described above and any one range of the absolute values of the refractive index difference as described above.

The refractive indices N1 and N2 may be measured by the method described in "1. Measurement of refractive index" in the examples section of the present specification.

The material constituting the main body of the light control film is not particularly limited. Typically, in the light control film, the main body may be formed by curing an acrylate material, and the main body formed by such a method may also be applied to the present application.

In one example, to improve the filling characteristics (filling rate and filling uniformity) of the above-described filling material, a main body having the improved tensile strength and elastic restoring force may be used as the main body.

In a process of manufacturing the light control film, a so-called scrubbing process may be applied to fill the grooves of the main body with the filling material. In this process, the filling material is filled into the groove while the main body is compressed using a compression means such as a knife, where in this process, as the main body has a higher strength, the filling rate may be increased by reducing the degree to which the main body is compressed.

When the pressure due to compression by the compression means has disappeared, the rate at which the main body is restored after being compressed also affects the filling rate, so that it is recommended to use a main body with an appropriate level of elastic restoring force.

In one example, the lower limit of the tensile strength of the main body may be 7 MPa, 7.1 MPa, 7.2 MPa, 7.3 MPa, 7.4 MPa, 7.5 MPa, 7.6 MPa, 7.7 MPa, 7.8 MPa, 7.9 MPa, 8 MPa, 8.1 MPa, 8.2 MPa, 8.3 MPa, 8.5 MPa, 9 MPa, 9.5 MPa, 10 MPa, 11 MPa, 12 MPa, or 13 MPa or so. The upper limit of the tensile strength of the main body may also be 20 MPa, 19 MPa, 18 MPa, 17 MPa, 16 MPa, 15 MPa, 14 MPa, 13 MPa, 12 MPa, 11 MPa, 10 MPa, 9 MPa, 8 MPa, or 7.5 MPa or so. The tensile strength of the main body may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. This tensile strength may be measured according to the method described in "2. Measurement of tensile strength" in Example section of the present specification.

For achieving the filing rate as described below, it may also be appropriate for the main body to have an appropriate elastic restoring force. For example, in a test applying a pencil durometer, when the main body has been pressurized with a 2H hardness pencil under a load of 300 g to made a mark, and then the pencil has been removed, the main body having a restoring force in a level that the mark made by the pencil disappears within 1 minute, 50 seconds, 40 seconds, 30 seconds, 20 seconds, or 10 seconds may be appropriate for forming the desired light control film. The restoring force may be evaluated by the method described "3. Evaluation of elastic restoring force" in Example section of the present specification.

The material forming the main body may be controlled to ensure the above characteristics.

In one example, the main body may comprise an acrylic polymer.

The term acrylic polymer means a cross-linked product, polymerization product, or cross-linked and polymerization product of an acrylate.

The term acrylate means a monomer, an oligomer, or other precursors having one or more (meth)acryloyl groups, and forming the acrylic polymer by polymerization and/or crosslinking, and an example thereof includes acrylic acid, methacrylic acid, acrylic acid ester, or methacrylic acid ester, and the like.

In this specification, the term (meth)acryloyl group means an acryloyl group or a methacryloyl group.

Regarding the content of the acrylic polymer in the main body, the lower limit thereof may be 55 wt%, 60 wt%, 65

wt%, 70 wt%, 75 wt%, 80 wt%, 85 wt%, 90 wt% or 95 wt% or so, and the upper limit thereof may be 100 wt%, 99 wt%, or 98 wt% or so, based on the total weight of the main body. The ratio may also be within a range of more than or equal to, or more than any one of the above-described lower limits; or within a range of more than or equal to, or more than any one of the above-described lower limits, while being within a range of less than or equal to, or less than any one of the above-described upper limits.

In one example, the acrylic polymer may contain a specific type of bond to secure the tensile strength and/or restoration properties as described above.

For example, the acrylic polymer may contain a bond represented by Formula 1 below and/or a bond represented by Formula 2 below. The acrylic polymer may contain any one of the bonds of Formulas 1 and 2 below, or may contain both.

[Formula 1]

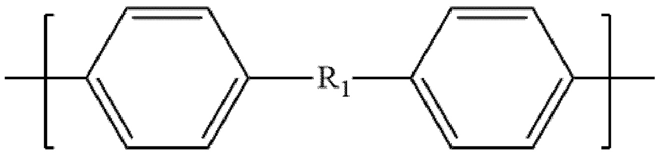

In Formula 1, $R_1$ is a single bond, an alkylene group, or an alkylidene group.

In Formula 1, the matter that $R_1$ is a single bond means that $R_1$ does not exist and the benzene rings on both sides of $R_1$ are directly connected to form a biphenyl structure.

In the structure of Formula 1, the benzene structure, alkylene group, and/or alkylidene group may be optionally substituted with one or more substituents, if necessary.

[Formula 2]

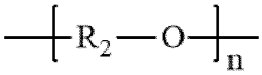

In Formula 2, $R_2$ is an alkylene group or an alkylidene group, and n is an arbitrary number.

The lower limit of n in Formula 2 may be 1, 2, 3, 4, 5, 6, 7, 8, 9, 10, 11, 12, 13, 14, 15, 16, 17, 18, 19, or 20 or so, and the upper limit of n may be 50, 45, 40, 35, 30, 25, 20, 19, 18, 17, 16, 15, 14, 13, 12, 11, 10, 9, 8, 7, 6, 5, or 4 or so. The n may also be within a range of more than or equal to, or more than any one of the above-described lower limits, while being within a range of less than or equal to, or less than any one of the above-described upper limits.

In Formulas 1 and 2, the term alkylene group means a functional group in which two hydrogen atoms are separated from an alkane and connected to another object, where the two hydrogen atoms are separated from other carbon atoms of the alkane. Such an alkylene group may be an alkylene group with 2 to 20 carbon atoms, 2 to 16 carbon atoms, 2 to 12 carbon atoms, 2 to 8 carbon atoms, or 2 to 4 carbon atoms. Such an alkylene group may be linear, branched, or cyclic. Such an alkylene group may also be optionally substituted with one or more substituents. Particularly, the alkylene group in Formula 1 may also be optionally substituted with one or more halogens. In this instance, the applied halogen may be exemplified by fluorine, chlorine, or iodine, and the like, but is not limited thereto.

In this specification, unless otherwise specified, the term alkylidene group is a functional group in which two hydrogen atoms are separated from an alkane and connected to another object, which means a structure in which the two hydrogen atoms are separated from one carbon atom of the alkane. Such an alkylidene group may be an alkylidene group with 1 to 20 carbon atoms, 1 to 16 carbon atoms, 1 to 12 carbon atoms, 1 to 8 carbon atoms, or 1 to 4 carbon atoms. Such an alkylidene group may be linear, branched, or cyclic. Such an alkylidene group may also be optionally substituted with one or more substituents. Particularly, the alkylidene group in Formula 1 may also be optionally substituted with one or more halogens. In this instance, the applied halogen may be exemplified by fluorine, chlorine, or iodine, but is not limited thereto.

The bond may contribute to the main body to exhibit appropriate levels of tensile strength and/or restoration properties, and may also contribute thereto to adjust the refractive index of the main body to an appropriate level.

A method of introducing the above bond into the acrylic polymer is not particularly limited.

For example, a method of forming the acrylic polymer using a monomer containing such a bond in the molecular structure as the acrylate can be used.

Therefore, the acrylic polymer may contain an acrylate unit having the bond of Formula 1 above, an acrylate unit having the bond of Formula 2 above, and/or an acrylate unit having the bond of Formula 1 above and the bond of Formula 2 above.

The acrylate unit means the state where the acrylate is contained in the acrylic polymer after polymerization or

crosslinking.

In this case, the lower limit of the ratio of the acrylate unit containing the bond of Formula 1 above based on the total weight of the acrylate unit included in the acrylic polymer may be 20 wt%, 25 wt%, 30 wt%, 35 wt%, 40 wt%, 45 wt%, 50 wt%, 55 wt%, 60 wt%, 65 wt%, 70 wt%, 75 wt%, 80 wt%, or 85 wt% or so, and the upper limit thereof may also be 99 wt%, 95 wt%, 90 wt%, 85 wt%, 80 wt%, 75 wt%, 70 wt%, 65 wt%, 60 wt%, 55 wt%, 50 wt%, 45 wt%, 40 wt%, 35 wt%, or 30 wt% or so. The content may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The lower limit of the ratio of the acrylate unit containing the bond of Formula 2 above based on the total weight of the acrylate unit included in the acrylic polymer may be 5 wt%, 10 wt%, 15 wt%, 20 wt%, 25 wt%, 30 wt%, or 35 wt% or so, and the upper limit thereof may also be 50 wt%, 45 wt%, 40 wt%, 35 wt%, 30 wt%, 25 wt%, 20 wt%, or 15 wt% or so. The content may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In the acrylic polymer, the unit other than the acrylate unit having the bond of Formula 1 above, the acrylate unit having the bond of Formula 2 above, and the acrylate unit having the bond of Formula 1 above and the bond of Formula 2 above is an acrylate unit without the bond of Formula 1 above and the bond of Formula 2 above, or other monomer units other than the acrylate.

For control of the tensile strength and/or restoration properties, the acrylate may be a polyfunctional monomer with bifunctionality or more. Here, the matter that the monomer has bifunctionality or more means the case where the number of (meth)acryloyl groups contained in the monomer is 2 or more, 3 or more, 4 or more, or 5 or more. The number of functional groups included in the polyfunctional monomer may also be 10 or less, 9 or less, 8 or less, 7 or less, 6 or less, 5 or less, 4 or less, or 3 or less or so. The number of functional groups may be adjusted between any one of the above-described upper limits and any one of the above-described lower limits. In one example, the number of (meth)acryloyl groups included in the polyfunctional monomer may be 2, or 3.

The lower limit of the ratio of the polyfunctional acrylate unit based on the total weight of the acrylate units included in the acrylic polymer may be 5 wt%, 10 wt%, 15 wt%, 20 wt%, 25 wt%, 30 wt%, 35 wt%, 40 wt%, 45 wt%, 50 wt%, or 55 wt% or so, and the upper limit thereof may also be 80 wt%, 75 wt%, 70 wt%, 65 wt%, 60 wt%, 55 wt%, 50 wt%, 45 wt%, 40 wt%, 35 wt%, 30 wt%, or 20 wt% or so. The content may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The acrylic polymer may contain a monofunctional acrylate unit in addition to the polyfunctional acrylate unit. The monofunctional acrylate means a monomer having one of the (meth)acryloyl group.

The lower limit of the weight ratio of the monofunctional acrylate unit relative to 100 parts by weight of the polyfunctional acrylate unit may be 10 parts by weight, 15 parts by weight, 20 parts by weight, 25 parts by weight, 30 parts by weight, 35 parts by weight, 40 parts by weight, 45 parts by weight, 50 parts by weight, 55 parts by weight, 60 parts by weight, 65 parts by weight, or 70 parts by weight or so, and the upper limit may also be 150 parts by weight, 145 parts by weight, 140 parts by weight, 135 parts by weight, 130 parts by weight, 125 parts by weight, 120 parts by weight, 115 parts by weight, 110 parts by weight, 105 parts by weight, 100 parts by weight, 95 parts by weight, 90 parts by weight, 85 parts by weight, 80 parts by weight, 75 parts by weight, 70 parts by weight, 65 parts by weight, 60 parts by weight, 55 parts by weight, or 50 parts by weight or so. The ratio may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The monofunctional and/or polyfunctional acrylate may include the bond of Formula 1 and/or Formula 2 as described above.

The specific type of the polyfunctional acrylate is not particularly limited. For example, the applicable polyfunctional acrylate may be exemplified by one, or two or more selected from the group consisting of a bifunctional type such as 1,4-butanediol di(meth)acrylate, 1,6-hexanediol di(meth)acrylate, neopentyl glycol di(meth)acrylate, hydroxypivalic acid neopentyl glycol di(meth)acrylate, dicyclopentanyl di(meth)acrylate, caprolactone modified dicyclopentenyl di(meth) acrylate, ethylene oxide modified phosphoric acid di(meth)acrylate, di(meth)acryloxy ethyl isocyanurate, allylated cyclohexyl di(meth)acrylate, tricyclodecane dimethanol di(meth)acrylate, dimethyloldicyclopentane di(meth)acrylate, ethylene oxide modified hexahydrophthalic acid di(meth)acrylate, neopentyl glycol modified trimethylolpropane di(meth)acrylate, adamantane di(meth)acrylate and 9,9-bis[4-(2-acryloyloxyethoxy)phenyl]fluorene; a trifunctional type such as trimethylolpropane tri(meth)acrylate, dipentaerythritol tri(meth)acrylate, propionic acid modified dipentaerythritol

tri(meth)acrylate, pentaerythritol tri(meth)acrylate, propylene oxide modified trimethylolpropane tri(meth)acrylate and tris(meth)acryloxyethyl isocyanurate; a tetrafunctional type such as diglycerin tetra(meth)acrylate and pentaerythritol tetra(meth)acrylate; a pentafunctional type such as propionic acid modified dipentaerythritol penta(meth)acrylate; and a hexafunctional type such as dipentaerythritol hexa(meth)acrylate and caprolactone modified dipentaerythritol hexa(meth) acrylate.

The monofunctional acrylate may be exemplified by alkyl (meth)acrylate, hydroxyalkyl (meth)acrylate, or glycidyl (meth)acrylate, and the like, but is not limited thereto.

The polyfunctional or monofunctional acrylate containing the bond of Formula 1 and/or 2 above may be exemplified by bisphenol diacrylate such as modified bisphenol fluorine diacrylate, bisphenol A ethoxylated diacrylate, ortho-phenyl phenoxyl ethyl acrylate (OPPEA), and/or phenylbenzyl acrylate, and the like, but is not limited thereto.

The main body can be formed using known means such as an imprinting method, a press method, or an injection molding method, using a curable material comprising the above material.

The main body may typically have a thickness in a range of 50$\mu$m to 500$\mu$m.

In the groove formed in the main body, a filling material is present, where the filling material includes a light absorbing material.

Various types of filling materials for constructing a light control film are known, and the known materials may also be used in the present application.

Typically, the filling material comprises a resin material acting as a binder, and a coloring material, a pigment, or a dye, and the like, which is a light absorbing material. The applicable light absorbing material may be exemplified by a black pigment or dye such as carbon black, or those obtained by dyeing resin particles, for example, transparent particles such as acrylic polymer particles, and the like with the black pigment such as carbon black, and the like. In addition to the black pigment, a mixture of various pigments of blue, purple, yellow and red, and/or dyes, or a material substantially formed to black by mixing and dispersing the black coloring material with a blue, purple, yellow, or red coloring material may also be used. The blue pigment may be exemplified by copper phthalocyanine, and the like; the purple pigment may be exemplified by dioxazine violet, and the like; the yellow pigment may be exemplified by disazo yellow, and the like; and the red pigment may be exemplified by black horse phthal red tie pel, and the like, without being limited thereto, and in addition to the pigments, dyes may also be used.

The type of binder included in the filling material is not particularly limited, and an appropriate type may be selected in consideration of the dispersibility of the light absorbing material and the desired refractive index relationship with the main body, and the like. Usually, reactive oligomers (epoxy acrylate-based, urethane acrylate-based, polyether acrylate-based, polyester acrylate-based, polythiol-based, etc.) or reactive monomers (vinyl pyrrolidone, 2-ethylhexyl acrylate, beta-hydroxyacrylate, tetrahydrofurfuryl acrylate, etc.) may be applied, but the applicable material is not limited to the foregoing.

The light control film may comprise additional constitutions in addition to the above constitutions.

For example, the light control film may comprise a base film formed on one or both sides of the main body.

Figure 7 shows a case where the base film (2000) is formed on one side of the main body (100) disclosed in Figure 1. In Figure 7, the base film (2000) is present only on one side of the main body (100), but the film (2000) may also be present on both sides of the main body (100).

The specific type of the base film is not particularly limited. For example, as the base film, an anisotropic polymer film to which optical anisotropy is imparted by stretching, or an isotropic film without optical anisotropy, and the like may be used. The polymer film may be exemplified by, for example, a polyolefin film such as a polyethylene film or a polypropylene films, a cycloolefin polymer (COP) film such as a polynorbornene film, a polyvinyl chloride film, a polyacrylonitrile film, a poly sulfone film, a polyacrylate film, a PVA (poly(vinyl alcohol)) film, or a cellulose ester-based polymer film such as a TAC (triacetyl cellulose) film, a polyester film, or a polycarbonate films, or a copolymer film of two or more monomers among monomers forming the polymer, and the like.

By applying an anisotropic polymer film with a large in-plane phase difference as the base film, it is possible to effectively provide a light control film preventing appearance defects.

In one example, the lower limit of the in-plane phase difference (based on a wavelength of 550 nm) of the anisotropic polymer film may be 8,000 nm, 9,000 nm, 10,000 nm, 11,000 nm, or 12,000 nm or so, and the upper limit thereof may also be 100,000 nm, 90,000 nm, 80,000 nm 70,000 nm, 60,000 nm, 50,000 nm, 40,000 nm, 30,000 nm, 20,000 nm, 15,000 nm, 14,000 nm, 13,000 nm, or 12,000 nm or so. The in-plane phase difference may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. By applying a base film having such an in-plane phase difference, it is possible to suppress the occurrence of rainbow patterns or other stains even when the light control film is exposed to polarized light, and the like.

The in-plane phase difference is a physical quantity according to Equation 4 below.

[Equation 4]

$$Rin = d \times (nx - ny)$$

In Equation 4, Rin is the in-plane phase difference, nx is the refractive index of the film in the slow axis direction, ny is the refractive index of the film in the fast axis direction, and d is the thickness of the film. Here, the meanings of the slow axis and the fast axis are known in the industry.

The type of base film is not particularly limited.

For example, a representative example of a film exhibiting such an in-plane phase difference known in the industry is a stretched polyester film such as a stretched PET (poly(ethyleneterephthalate)) film.

Therefore, the base film may be the polyester film, but is not limited thereto.

As described above, if the groove formed in the main body is formed to represent a straight-line shape when the first surface is observed in the normal direction of the first surface of the main body, the lower limit of the angle formed by the slow axis of the base film and the straight-line shape may be 80 degrees, 85 degrees, or 90 degrees or so, and the upper limit thereof may be 90 degrees, or 85 degrees or so. The angle may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In another example, as described above, if the groove formed in the main body is formed to represent a straight-line shape when the first surface is observed in the normal direction of the first surface of the main body, the lower limit of the angle formed by the slow axis of the base film and the straight-line shape may be 0 degrees, 2 degrees, 4 degrees, 6 degrees, 8 degrees, or 10 degrees or so, and the upper limit thereof may be 10 degrees, 8 degrees, 6 degrees, 4 degrees, or 2 degrees or so. The angle may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

The base film may typically have a thickness in a range of 5μm to 500μm, but is not limited thereto.

In one example, the light control film may comprise a pressure-sensitive adhesive layer or adhesive layer formed on one or both sides of the main body. The pressure-sensitive adhesive layer or adhesive layer is applied to attach the light control film to a display device, and the like. Figure 8 shows a case where the pressure-sensitive adhesive layer (3000) is formed on one side of the main body (100). In the case of Figure 8, the pressure-sensitive adhesive layer is formed on the first surface of the main body (100), and in this case, the first surface typically becomes a light input surface. The pressure-sensitive adhesive layer may also be formed on the second surface of the main body.

The type of the pressure-sensitive adhesive layer or adhesive layer is not particularly limited. For example, an acrylic or silicone-based adhesive, and the like known in the industry as a so-called OCA (Optical Clear Adhesive) may be applied.

The thickness of the pressure-sensitive adhesive layer or adhesive layer is usually in a range of 1μm to 100μm, but is not limited thereto.

In the light control film, any other constitutions required in addition to the above constitutions may also exist.

The present specification discloses a device to which the light control film is applied, for example, a display device.

The specific type of the display device to which the light control film may be applied is not particularly limited. For example, the light control film may be applied to an LCD (Liquid Crystal Display), OLED (Organic Light Emitting Diode) display, or PDP (Plasma Display Panel), and the like.

Even if the light control film is applied to a device, such as an OLED (Organic Light Emitting Diode) display, in which the light control film is disposed relatively close to an observer, among various display devices, without any element, such as a backlight, diffusion film, or prism film, capable of compensating for defects which can appear by the light control film, it is possible to provide a light control film which does not generate defects such as stripes that can be recognized by the observer, while exerting the desired performance.

Accordingly, the present specification discloses an OLED (Organic Light Emitting Diode) display (organic light emitting device) to which the light control film is applied.

The display may typically comprise an organic light-emitting panel and the light control film disposed on a viewing side of the organic light-emitting panel.

A polarizing layer is usually disposed on the viewing side of the OLED (Organic Light Emitting Diode) display for antireflection, and the like.

Therefore, the OLED (Organic Light Emitting Diode) display may further comprise a polarizing layer on the viewing side.

In this case, the light control film may be disposed between the polarizing layer and the organic light-emitting panel, or on the side surface of the polarizing layer opposite to the surface facing the organic light-emitting panel.

Here, for example, as shown in Figure 2, if the groove is formed to represent a straight-line shape when the first surface is observed in the normal direction of the first surface of the main body of the light control film, the lower limit of the angle formed by the straight-line shape of the groove and the light absorption axis of the polarizing layer may be 1 degree, 2 degrees, 3 degrees, 4 degrees, 5 degrees, 6 degrees, 7 degrees, 8 degrees, 9 degrees, or 11 degrees or so, and the upper limit thereof may be 30 degrees, 29 degrees, 28 degrees, 27 degrees, 26 degrees, 25 degrees, 24 degrees, 23 degrees, 22 degrees, 21 degrees, 20 degrees, 19 degrees, 18 degrees, 17 degrees, 16 degrees, 15 degrees, 14 degrees, 13 degrees, 12 degrees, 11 degrees, 10 degrees, 9 degrees, 8 degrees, 7 degrees, 6 degrees, 5 degrees, 4 degrees, or 3 degrees or so. The angle may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

When the light control film is disposed depending on the type of the OLED (Organic Light Emitting Diode) display as described above, the distance between the polarizing layer and the light control film may vary, where to prevent defects such as ghosts or moire, the refractive index relationship between the main body and the filling material of the light control film may be controlled depending on the distance.

For example, the properties of the light control film may be adjusted to secure desired properties depending on the distance between the polarizing layer and the first surface.

For example, the case where the distance between the polarizing layer and the first surface is 250 μm or less is referred to as a first aspect, and the case where the distance is more than 250 μm is referred to as a second aspect, and thus the properties are explained as follows.

In the first aspect, the upper limit of the distance between the polarizing layer and the first surface may be 240 μm, 230 μm, 220 μm, 210 μm, 200 μm, or 195 μm or so, and the lower limit thereof may be 50 μm, 100 μm, 150 μm, or 185 μm or so. The distance may be within a range of less than or equal to, or less than any one of the above-described upper limits; or within a range of more than or equal to, or more than any one of the above-described lower limits, while being within a range of less than or equal to, or less than any one of the above-described upper limits.

In the case of the first aspect, the refractive index N1 of the main body and the refractive index N2 of the filling material may satisfy the relationship of N1>N2.

In this case, the lower limit of the difference N1-N2 between the refractive indices N1 and N2 may be 0.01, 0.015, 0.02, 0.025, 0.03, 0.035, 0.04, 0.045, 0.05, 0.055, 0.06, or 0.065 or so, and the upper limit thereof may be 0.08, 0.075, 0.07, 0.065, 0.06, 0.055, 0.05, 0.045, 0.04, or 0.035 or so. The N1-N2 may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In this case, the first surface of the main body of the light control film may be disposed closer to the polarizing layer than the second surface, or the second surface may be disposed closer to the polarizing layer than the first surface.

In the first aspect, the lower limit of the aperture ratio (aperture ratio of the transmission region) on the first surface of the main body of the light control film may be 60%, 65%, 70%, 75%, or 80% or so. The upper limit of the aperture ratio (aperture ratio of the transmission region) on the first surface may be 100%, 95%, 90%, 85%, 80%, 75%, 70%, or 65% or so. The aperture ratio may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. The meaning of the aperture ratio on the first surface is as described above.

In this case, the ratio (O2/O1) of the aperture ratio (O1) on the first surface and the aperture ratio (O2) on the second surface of the light control film may be within a predetermined range. For example, the lower limit of the ratio (O2/O1) may be 1, 1.01, 1.05, 1.1, 1.15, 1.2, 1.25, 1.3, 1.35, or 1.4 or so, and the upper limit thereof may be 5, 4.5, 4, 3.5, 3, 2.5, 2, 1.5, 1.4, 1.3, 1.2, or 1.1 or so. The ratio O2/O1 may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

Figure 11 is a schematic diagram of an OLED display having the above structure. Such an OLED display comprises an OLED panel (1), a color filter (2), a polarizing layer (3), and the light control film (4), wherein the distance between the polarizing layer (3) and the first surface of the main body of the light control film (4) mainly depends on the pressure-sensitive adhesive layer or adhesive layer (3000) to which the light control film (4) is attached.

In the second aspect, the lower limit of the distance between the polarizing layer and the first surface may be 250 μm, 260 μm, 270 μm, 280 μm, 290 μm, 300 μm, 310 μm, 320 μm, 330 μm, 340 μm, or 350 μm or so, and the upper limit

thereof may be 1000 μm, 900 μm, 800 μm, 700 μm, 600 μm, 500 μm, or 400 μm or so. The distance may be within a range of more than or equal to, or more than any one of the above-described lower limits; or within a range of more than or equal to, or more than any one of the above-described lower limits, while being within a range of less than or equal to, or less than any one of the above-described upper limits.

In the case of the second aspect, the refractive index N1 of the main body and the refractive index N2 of the filling material may satisfy the relationship of N1>N2.

In this case, the lower limit of the difference N1-N2 between the refractive indices N1 and N2 may be 0.01, 0.015, 0.02, 0.025, 0.03, 0.035, 0.04, 0.045, or 0.05 or so, and the upper limit thereof may be 0.08, 0.075, 0.07, 0.065, 0.06, 0.055, 0.05, 0.045, 0.04, 0.035, 0.03, or 0.025 or so. The N1-N2 may be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

In such a case, the first surface of the main body of the light control film may be disposed closer to the polarizing layer than the second surface, or the second surface may be disposed closer to the polarizing layer than the first surface.

In the second aspect, the lower limit of the aperture ratio (aperture ratio of the transmission region) on the first surface of the main body of the light control film may be 60%, 65%, 70%, 75%, or 80% or so. The upper limit of the aperture ratio (aperture ratio of the transmission region) on the first surface may be 100%, 95%, 90%, 85%, 80%, 75%, 70%, or 65% or so. The aperture ratio may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits. The meaning of the aperture ratio on the first surface is as described above.

In this case, the ratio (O2/O1) of the aperture ratio (O1) on the first surface and the aperture ratio (O2) on the second surface of the light control film may be within a predetermined range. For example, the lower limit of the ratio (O2/O1) may be 1, 1.01, 1.05, 1.1, 1.15, 1.2, 1.25, 1.3, 1.35, or 1.4 or so, and the upper limit thereof may be 5, 4.5, 4, 3.5, 3, 2.5, 2, 1.5, 1.4, 1.3, 1.2, or 1.1 or so. The ratio O2/O1 may also be within a range of less than or equal to, or less than any one of the above-described upper limits; or within a range of more than or equal to, or more than any one of the above-described lower limits; or within a range of more than or equal to, or more than any one of the above-described lower limits, while being within a range of less than or equal to, or less than any one of the above-described upper limits.

Figure 12 is a schematic diagram of an OLED display having the above structure. Such an OLED display comprises an OLED panel (1), a color filter (2), a polarizing layer (3), a transparent substrate (5), and the light control film (4), wherein the distance between the polarizing layer (3) and the first surfaces of the main body of the light control film (4) mainly depends on the pressure-sensitive adhesive layer or adhesive layer (3000) attaching the light control film (4), and the transparent substrate (5).

When the light control film is applied to the OLED display, by controlling the relationship of the refractive indices as above depending on the distance from the polarizing layer, it is possible to precisely control the light-outgoing angle, and it is possible to secure high transmittance, high luminance, and excellent resolution within the light-outgoing angle, while preventing defects such as ghosts or moire, and appearance defects that can be caused by the light control film.

[Effects of Invention]

The present specification discloses a light control film, and a display device to which the light control film is applied. The light control film enables precise control of a light-outgoing angle, can secure high transmittance, high luminance, and excellent resolution within the light-outgoing angle, and block unnecessary light capable of causing defects such as so-called ghosts or moire, as it is applied to a display device. Even when the light control film is applied to an OLED display, the light control film exhibits the above performance, and simultaneously prevents defects, such as stripes, that can be recognized by an observer from occurring. The present specification also discloses a display device to which the light control film is applied.

[Brief Description of Drawings]

Figure 1 is a cross-sectional diagram of a main body of an exemplary light control film of the present application.

Figure 2 is a diagram when a main body is observed in the normal direction of a first surface of the main body.

Figure 3 is a diagram showing a form in which a filling material is filled in a groove of a main body.

Figure 4 is a diagram for explaining first and second sides of the groove.

Figure 5 is a diagram for explaining sides A and B of the groove.

Figure 6 is a diagram for explaining a specific shape of a terminal part.

Figure 7 is a diagram of a light control film further comprising a base film.

Figure 8 is a diagram of a light control film further comprising a pressure-sensitive adhesive layer or adhesive layer.

Figure 9 is an SEM image of a light control film cross section.

Figure 10 shows the results of evaluating the luminance of the light control film at each viewing angle.

Figures 11 and 12 are diagrams for explaining OLED displays to which light control films are applied.

[Mode for Invention]

Hereinafter, the light control film, and the like will be described in more detail through examples and comparative examples, but the scope of the light control film, and the like is not limited by the following examples.

**Preparation Example 1. Preparation of light control film main body**

A material (main body material) for forming a main body of a light control film was prepared in a solventless form by mixing, as curable compounds, modified bisphenol fluorine diacrylate (A) (Miwon Specialty Chemical, Miramer HR6100), TMPTA (Trimethylolpropane triacrylate) (B), bisphenol A ethylene glycol diacrylate (C) (Cas No. 64401-02-1), OPPEA (Ortho-Phenyl Phenoxyl Ethyl Acrylate) (D), and PBA (phenylbenzyl acrylate) (E). The mixing ratio of the above materials was set to a weight ratio (A: B: C: D: E) of about 10: 6: 23: 13: 13 or so. The main body material was prepared by adding an initiator (Darocur 1173, Ciba Specialty Chemicals) to the above materials in a ratio of about 1 part by weight relative to 100 parts by weight of the total of the components A to E.

The main body of the light control film was manufactured using the main body material. The main body was manufactured in the manner disclosed in a document of WO2021/145469A1.

The main body of the light control film was manufactured by unwinding a base film (210) from the film supply device (10) disclosed in Figure 1 of the document and simultaneously supplying it, supplying the material to a coating device (20) to form a resin layer (220') on the base film (210), and irradiating the resin layer (220') imprinted by a pattern forming mold (30) with light by a curing device (40) to cure it, and recovered to a collecting device (50).

Grooves with a desired shape were formed by controlling the mold shape of the pattern forming mold (30).

The light irradiation was performed using a high-pressure metal halide lamp, and the irradiation wavelength range was in a range of 200 nm to 600 nm.

In the above process, SKC's OCF (Optical axis Control Film) (thickness: 125μm) was used as the base film (210). The in-plane phase difference of the base film was in a level of about 11,000 nm to 14,000 nm or so when measured in the manner described below.

The main body of the light control film formed according to Preparation Example 1 above comprises the base film, and the main body formed on one side of the film, where the portion of the main body in contact with the base film becomes the second surface (1002 in Figure 1).

**Preparation Example 2. Preparation of filling material including light absorbing material**

A filling material was prepared by blending carbon black as a light absorbing material into a resin material. The resin material was prepared by mixing aliphatic urethane diacrylate (Photomer 6210, Cognis) (F) and carbon black (carbon black alone and powder obtained by converting carbon black into acrylic beads) (G). The mixing ratio of the above materials was set to a weight ratio (F: G) of about 67:20 or so.

**1. Measurement of refractive index**

**Refractive index of main body (transmission region)**

Two glass plates that had been subjected to release treatment were spaced apart at an interval of about 100 μm

or so using a gap spacer, and the main body material obtained in Preparation Example 1 was injected between the two glass plates, and then cured. The curing was performed by light irradiation in the same manner as in Preparation Example 1. The refractive index was measured for the cured material. The refractive index was measured using an ABBE refractometer nD Brix DR-M4 equipment, and measured at a reference wavelength of about 589 nm.

**Refractive index of absorption region**

In the case of the filling material forming the absorption region, carbon black, which is a light absorption material, is included, so that it is not easy to directly measure the refractive index. In this case, the refractive index of the final filling material can be identified by measuring the refractive index in the same manner as measuring the refractive index of the main body (transmission region) for the material excluding the carbon black from the same composition as the filling material, and considering the amount of carbon black added. According to the Linear Mixing Rule, whenever the amount of carbon black in the filling material increases by about 1 wt%, the refractive index due to the addition of the relevant carbon black increases by about 0.009, so that based on this, the refractive index of the absorption region can be calculated. The reference wavelength of the refractive index calculated in this example is the same as the reference wavelength of the refractive index of the main body.

**2. Measurement of tensile strength**

Regarding a tensile strength, for a specimen with a horizontal length of about 45 mm, a vertical length of about 12.5 mm, and a thickness of about 2 mm or so, the tensile strength was measured at room temperature (about 25°C) using UTM (Universal Testing Machine) equipment. For example, the specimen can be manufactured by curing the main body material described in Preparation Example 1 to the size, where the curing conditions are the same as in Preparation Example 1. Both ends of the specimen in the transverse direction are fixed to the equipment by about 8 mm, and the strength at the point when the specimen breaks is measured while the specimen is stretched in the transverse direction at a speed of approximately 50 mm/sec, where the strength is referred to as the tensile strength. As a result of measurement in this way, the tensile strength of the main body material was about 13 MPa.

**3. Evaluation of elastic restoring force**

An elastic restoring force was evaluated for the specimen used in the measurement of tensile strength using a pencil durometer. The specimen was loaded into the pencil durometer, a load of about 300 g was applied to the main body with a 2H hardness pencil and the pencil was simultaneously advanced in one direction at a speed of 20 mm/sec to create a mark, and then the pencil was removed, and it was confirmed whether the mark created by the pencil disappeared. As a result of performing the measurement on the main body, the mark created by the 2H hardness pencil disappeared within 10 seconds. The measurement was performed at room temperature (about 25°C).

**4. In-plane phase difference evaluation of base film**

An in-plane phase difference value (Rin) of a base film was measured for light with a wavelength of 550 nm using Agilent's UV/VIS spectroscope 8453 equipment. Two polarizers were installed on the UV/VIS spectroscope so that their transmission axes were orthogonal to each other, and the base film was installed between the two polarizers so that its slow axis formed at 45 degrees with the transmission axes of the two polarizers, respectively, and then the transmittance according to the wavelength was measured. The phase retardation order of the respective peaks is obtained from the transmittance graph according to wavelengths. Specifically, in the transmittance graph according to wavelengths, the waveform satisfies Equation A below, and in the sine waveform, the maximum peak (Tmax) condition satisfies Equation B below. In the case of λmax in Equation A, T in Equation A and T in Equation B are the same, so that the equations are developed. If the equations are also developed for n+1, n+2, and n+3, and n is organized into the λn and λn+1 equations by organizing the n and n+1 equations to eliminate R, the following Equation C is derived. Since n and λ can be found based on that T in Equation A and T in Equation B are the same, R is obtained for each of λn, λn+1, λn+2, and λn+3. For 4 points, a straight trend line of the R value according to wavelengths is obtained, and the R value for the equation 550 nm is calculated. The function of the straight trend line is Y=ax+b, where a and b are constants. The Y value when 550nm is substituted for x in the above function is the Rin value for light with a wavelength of 550nm.

[Equation A]

$$T = \sin^2[(2\pi R/\lambda)]$$

[Equation B]

$$T = \sin^2[((2n+1)\pi/2)]$$

[Equation C]

$$n = (\lambda n\ -3\lambda n+1)/(2\lambda n+1\ +1-2\lambda n)$$

Here, R means the in-plane phase difference (Rin), λ means the wavelength, and n means the peak order of the sine waveform.

Example 1.

A main body of a light control film was manufactured according to the method described in Preparation Example 1. The shape of the manufactured main body will be described with reference to the drawings. As shown in Figure 1, the main body was manufactured so that it had a first surface (1001) and a second surface (1002), and included a plurality of grooves (1003) extending from the first surface (1001) to the second surface (1002) (In Figure 1, the base film is present on the second surface (1002) of the main body).

The groove (1003) was formed so that when the main body was viewed toward the first surface (1001), the groove (1003) formed a straight line on the first surface (1001), as shown in Figure 2. At this time, the straight-line shape was formed at an angle of about 90 degrees with the slow axis of the base film.

In the above structure, it was formed for the pitch (P in Figure 1) of the groove (1003) to be about 40 μm or so; it was formed for the width ($W_1$ in Figure 1) of the groove (1003) on the first surface (1001) to be about 12 μm or so; it was formed for the width ($W_2$ in Figure 1, corresponding to the length of the opposite side (10) in Figure 6 below) of the end of the groove (1003) facing the second surface (1002) to be about 6 μm or so; it was formed for the depth ($H_T$ in Figure 1) of the groove to be about 90 μm or so; and it was formed for L in Figure 1 to be about 20 μm to 35 μm or so.

In the main body, the ratio of the area of the absorption region (total area of the absorption region with the width $W_1$ in Figure 1) to the total area of the first surface (1001) was about 30% or so. Therefore, the aperture ratio on the first surface (1001) is about 70%. Also, in the main body, the ratio of the area of the absorption region (total area of the absorption region with the width $W_2$ in Figure 1) to the total area of the second surface (1002) was about 15%. Therefore, the aperture ratio of the second surface (1002) is about 85% or so.

In Figure 4 of the main body, the angles corresponding to angles $\theta_1$ and $\theta_2$ were set to be about 2.5 degrees or so.

The first surface (1001) between the groove (1003) and the groove (1003) in the main body of the light control film was formed to have the shape shown in Figure 6. In Figure 6, the angle θ21 was set to be about 87.5 degrees or so, and the angle θ11 was set to be about 3 degrees or so. The length of the opposite side (10) in Figure 6 was about 6μm or so, and the length of the first inclined side (20) was about 11μm or so.

A light control film was manufactured by filling the grooves (1003) of the main body with the filling material prepared in Preparation Example 2 and curing it. The filling material was prepared in the same manner as in Preparation Example 2, but prepared so that by adjusting the amount of carbon black, the refractive index of the relevant filling material (absorption region) was about 1.48 or so. Since the refractive index of the main body (transmission region) is about 1.511 to 1.541 or so, the difference between the refractive index N1 of the transmission region and the refractive index N2 of the absorption region is about 0.03 to 0.06 or so. The filling of the filling material was performed through a scrubbing process. That is, the filling was performed by applying the filling material to the groove-formed surface of the main body, compressing the applied filling material using a knife to introduce the filling material into the grooves, and then removing the material other than that filled in the grooves. The curing of the filled material was performed by irradiating it with light (ultraviolet rays) in consideration of the composition of the filling material.

**Example 2.**

The main body of the light control film was formed in the same manner as in Example 1.

However, in this case, the shape of the groove was formed in a multi-stage structure as shown in Figure 5. In Figure 5, the angle θA was set to about 3 or so, and the angle θB was set to about 1.5 or so. Also, in Figure 5, the length of the first side (10031A) was set to about 120 μm or so, and the length of the second side (10031B) was set to about 30 μm or so.

In the case of the main body, the aperture ratio on the first surface (1001) was about 75.4% or so, the aperture ratio on the second surface (1002) was about 91% or so, and the pitch (the value corresponding to P of Figure 1 in Example 1) of the groove was about 61 μm or so, the width (the value corresponding to $W_1$ in Figure 1) of the lower end of the groove was

about 15 μm or so, and the width (the value corresponding to $W_2$ in Figure 1) of the upper end of the groove was about 5.47 μm or so.

Also, the depth (the value corresponding to $H_T$ in Figure 1) of the groove of the main body was about 150 μm or so. In addition to the foregoing, the angle formed by the straight-line shape of the groove and the slow axis of the base film, and L in Figure 1 were the same as in Example 1.

The filling of the filling material into the grooves (1003) of the main body was controlled in the same manner as in Example 1.

**Comparative Example 1.**

A light control film was manufactured in the same manner as in Example 1, except that as the material for forming the main body, a transparent resin material generally applied in the production of light control films was used rather than the material in Preparation Example 1. As a result of evaluating the tensile strength of this material in the above-described manner, it was about 5 MPa or so, and upon evaluation of the elastic restoring force, the mark did not disappear after removing the pencil.

**Test Example 1. Filling rate and appearance evaluation**

The filling characteristics of the filling materials of the light control films of Example 1 and Comparative Example 1 were evaluated through SEM images. The filling characteristics were evaluated by photographing the cross section of the light control film with SEM (scanning electron microscope) equipment (JEOL, JSM-7800F model). The light control film was subjected to cross-section treatment with the TXP preprocessing equipment, and then photographed with the SEM equipment. Upon the photographing, BED-C observation mode was applied, and the magnification, working distance, and acceleration voltage were set to 100 times, 15mm (Working Distance), and 15.0 kV, respectively. Figure 9 is an image photographed in the same manner as above for Example 1.

For the light control films of Example 1 and Comparative Example 1, the depth of the region where the filling material was not filled was confirmed for all grooves based on the SEM images. As shown in Figure 3, the depth of the region where the filling material (200) was not filled was evaluated by measuring the shortest distance (D1, D2, etc. in Figure 3) from the first surface (1001) of the main body to the filling material (200), where the first surface, as the standard for the depth, was a virtual surface or line (1001l in Figure 3) connecting the first surfaces (1001) present in both sides of the portion where the groove (1003) was formed. Also, in the case where two or more shortest distances were present, the shortest distance in calculating the average depth of the region where the filling material was not filled was the longest distance (D2 in the case of Figure 3) among the two or more shortest distances.

The depths of the unfilled regions of the respective grooves measured in the same manner as above were summarized in Table 1 below.

[Table 1]

| | Example 1 | Comparative Example 1 |
|---|---|---|
| Depth of unfilled region (μm) | 2.02 | 2.59 |
| | 2.32 | 2.27 |
| | 2.32 | 2.38 |
| | 2.15 | 2.24 |
| | 2.27 | 2.00 |
| | 2.06 | 2.56 |
| | 2.15 | 2.41 |
| | 2.16 | 2.24 |
| | 2.28 | 2.60 |
| | 1.97 | 2.47 |
| | 2.37 | 2.67 |
| | 2.09 | 2.47 |
| | 2.39 | 2.45 |
| | 2.38 | 2.04 |

(continued)

| | Example 1 | Comparative Example 1 |
|---|---|---|
| | 2.28 | 2.02 |
| | 1.93 | 2.18 |
| | 2.06 | 2.64 |
| | 2.20 | 2.43 |
| | 2.28 | 2.43 |
| | 2.12 | 2.29 |
| | 2.12 | 1.84 |
| | 1.81 | 2.17 |
| | 1.93 | 2.01 |
| | 2.18 | 2.49 |
| | 2.00 | 1.87 |
| | 2.49 | 2.37 |
| | 2.30 | 2.70 |
| | 2.23 | 2.63 |
| | 2.28 | 2.40 |
| | 2.11 | 2.37 |
| Average (μm) | 2.175 | 2.341 |
| Standard deviation (μm) | 0.16 | 0.24 |

From the results in Table 1, it can be known that Example 1 has a smaller average depth of the unfilled region and a smaller standard deviation of the depth relative to Comparative Example 1.

The presence of appearance defects in the respective light control films of Example 1 and Comparative Example 1 was evaluated. As the light control films were observed at a viewing angle of up to 20 degrees based on the normal direction of the surface of each light control film to confirm whether hairline defects, which were fine shading defects, were observed within the viewing angle, the presence of appearance defects was evaluated depending on whether the shading defects were observed. As a result, in Comparative Example 1, many hairline defects were observed within the viewing angle, but in the case of Example 1, the hairline defects were not observed throughout the entire viewing angle. As a result of the same evaluation for Example 2, the average of the depths of the unfilled regions was about 2.25 μm or so, the standard deviation was about 0.18 μm or so, and even in this case, the appearance defects were not observed.

**Test Example 2. Luminance measurement according to viewing angle**

For the light control film of Example 1, the refractive index N2 of the absorption region was fixed at 1.48, and the refractive index N1 of the transmission region was changed, whereby the luminance according to the viewing angle was evaluated, and the results were shown in Figure 10 below.

Here, the method of changing the refractive index N1 of the transmission region can be performed by changing the composition of the materials for the main body. In general, as the number of aromatic groups increases, the refractive index increases, so that the refractive index can be adjusted by changing the ratios of modified bisphenol fluorine diacrylate (A), bisphenol A ethylene glycol diacrylate (C), OPPEA (Ortho-Phenyl Phenoxyl Ethyl Acrylate) (D) and/or PBA (phenylbenzyl acrylate) (E) from the materials of the main body.

In Figure 10, N-1 to N-6 are cases where the differences (N1-N2) between the refractive index N1 of the transmission region and the refractive index N2 of the absorption region are 1.48, 1.49, 1.50, 1.51, 1.52, and 1.53, respectively, and in Figure 10, the X-axis is the viewing angle, and the Y-axis is the luminance. Through the results of Figure 10, it can be confirmed that light transmission can be controlled according to the viewing angle through the light control film of the present application.

**Example 3.**

A light control film was manufactured in the same manner as in Example 1, and a pressure-sensitive adhesive layer was formed on the first surface of the light control film, and then attached to an OLED to produce the OLED panel of Figure 11. Here, an acrylic OCA (Optically Clear Adhesive), which was commonly used for optical purposes, was used as the pressure-sensitive adhesive layer.

When applied to the structure of Figure 11, the refractive index of the main body of the light control film was set to be about 1.511 to 1.541 or so, and the refractive index of the filling material was adjusted by the amount of carbon black, whereby the difference (N1-N2) between the refractive index N1 in the transmission region and the refractive index N2 in the absorption region was set to be about 0.03 to 0.06 or so.

Also, in the structure of Figure 11, the aperture ratio on the lower surface (the surface in contact with the OCA in Figure 11) of the light control film was set to be about 70% to 74% or so, and the aperture ratio on the upper surface (the surface opposite to the lower surface) was set to be about 85% to 90% or so.

Since the thickness of the OCA in the above structure was around 190μm, the distance between the first surface of the main body of the light control film and the polarizing layer was approximately 190 μm or so. In the above structure, the angle formed between the absorption axis of the polarizing layer (pol) and the straight-line shape formed by the groove of the light control film (see Figure 2) was set to about 7 degrees to 8 degrees or so.

For the OLED with the above structure, appearance defects were evaluated according to the method of Test Example 1, and luminance depending on the viewing angle was evaluated according to Test Example 2, whereby it was confirmed that the appearance defects were not observed, and transmittance control characteristics were secured according to the viewing angle. In addition, defects such as a ghost phenomenon were not confirmed.

**Example 4.**

A light control film was manufactured in the same manner as in Example 1, and a pressure-sensitive adhesive layer was formed on the first surface of the light control film, and then attached to an OLED to produce the OLED panel with the same structure as Figure 12. An acrylic OCA (Optically Clear Adhesive), which was commonly used for optical purposes, was used as the pressure-sensitive adhesive layer.

When applied to the structure of Figure 12, the refractive index N1 of the main body of the light control film was set to be about 1.501 to 1.531 or so, and the refractive index of the filling material was adjusted by the amount of carbon black, whereby the difference (N1-N2) between the refractive index N1 in the transmission region and the refractive index N2 in the absorption region was set to be about 0.02 to 0.05 or so.

Also, in the structure below, the aperture ratio on the lower surface (the surface in contact with the OCA in Figure 12) of the light control film was set to be about 68% to 72% or so, and the aperture ratio on the upper surface (the surface opposite to the lower surface) was set to be about 87% to 91% or so.

Since the thickness of the OCA in the structure of Figure 12 was around 25μm, and the thickness of the glass substrate was around 300 μm, the distance between the first surface of the main body of the light control film and the polarizing layer was approximately 325 μm or so.

In the above structure, the angle formed between the absorption axis of the polarizing layer (pol) and the straight-line shape formed by the groove of the light control film (see Figure 2) was set to about 4 degrees to 6 degrees or so.

For the OLED with the above structure, appearance defects were evaluated according to the method of Test Example 1, and luminance depending on the viewing angle was evaluated according to Test Example 2, whereby it was confirmed that the appearance defects were not observed, and transmittance control characteristics were secured according to the viewing angle. In addition, defects such as a ghost phenomenon were not confirmed.

## Claims

1. A light control film comprising:

   a main body having a first surface and a second surface facing the first surface, in which a plurality of grooves extending toward the second surface is formed on the first surface;
   a filling material filled in the grooves and including a light absorbing material; and
   a base film present in one or both sides of the main body, wherein
   the base film has an in-plane phase difference of 8,000nm or more for a wavelength of 550 nm.

2. The light control film according to claim 1, wherein the groove formed in the main body is formed to represent a straight-line shape when the first surface is observed in the normal direction of the first surface of the main body, and the slow

axis of the base film and the straight-line shape are disposed to form an angle in a range of 80 degrees to 90 degrees or 0 degrees to 10 degrees.

**3.** The light control film according to claim 1, wherein in the plurality of grooves filled with the filling material, the average depth of regions unfilled with the filling material is in a range of 0μm to 3μm, and the standard deviation of the unfilled region depth is 0.2 or less.

**4.** The light control film according to claim 1, wherein the absolute value of the difference between the refractive index N1 of the main body and the refractive index N2 of the filling material is in a range of 0 to 0.1.

**5.** The light control film according to claim 1, wherein in the cross section of the main body, the groove has a first side extending from the first surface of the main body toward the second surface of the main body, and a second side facing the first side and extending from the first surface toward the second surface, and
a first angle formed by the first side and the normal direction of the first surface, and a second angle formed by the second side and the normal direction of the first surface are each in a range of 0 degrees to 10 degrees.

**6.** The light control film according to claim 5, wherein the first angle and the second angle are different from each other, where the first angle is 2 degrees or more, and the second angle is 2 degrees or less.

**7.** The light control film according to claim 1, wherein in the cross section of the main body, the groove has a first side extending from the first surface of the main body toward the second surface of the main body, and a second side facing the first side and extending from the first surface toward the second surface, and
the first side or the second side comprises a side A forming an angle A with the normal direction of the first surface, and a side B forming an angle B different from the angle A.

**8.** The light control film according to claim 7, wherein the side B is located closer to the second surface of the main body relative to the side A, and
the angle A is 3 degrees or more and the angle B is 2 degrees or less.

**9.** The light control film according to claim 7, wherein R of Equation 1 below is in a range of 5% to 40%:

[Equation 1]

$$R = (100 \times L_B \times \cos\theta_B)/(L_A \times \cos\theta_A + L_B \times \cos\theta_B)$$

wherein, $L_A$ is the length of the side A, $L_B$ is the length of the side B, $\theta_A$ is the angle A, and $\theta_B$ is the angle B.

**10.** The light control film according to claim 1, wherein the depth of the groove formed in the main body is in a range of 50 μm to 200 μm,

the pitch of the plurality of grooves formed in the main body is in a range of 10 μm to 100 μm, and
the width of the groove formed on the first surface of the main body is in a range of 1 μm to 50 μm.

**11.** The light control film according to claim 1, wherein the main body has a tensile strength of 7 MPa or more.

**12.** The light control film according to claim 1, wherein the main body comprises an acrylic polymer containing one or more bonds selected from the group consisting of a bond of Formula 1 below and a bond of Formula 2 below:

[Formula 1]

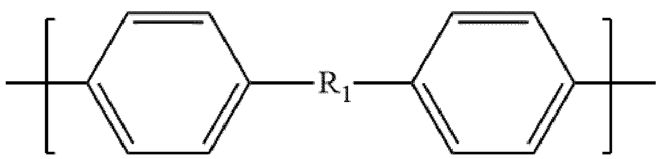

wherein, $R_1$ is a single bond, an alkylene group, or an alkylidene group,

[Formula 2]

$$-\!\left[R_2-O\right]_n\!-$$

wherein, $R_2$ is an alkylene group or an alkylidene group, and n is a number in a range of 1 to 50.

**13.** The light control film according to claim 12, wherein the acrylic polymer comprises acrylate units having one or more bonds selected from the group consisting of the bond of Formula 1 and the bond of Formula 2.

**14.** The light control film according to claim 13, wherein the ratio of the acrylate unit containing the bond of Formula 1 is in a range of 20 wt% to 90 wt%, based on the total weight of the acrylate units included in the acrylic polymer.

**15.** The light control film according to claim 13, wherein the ratio of the acrylate unit containing the bond of Formula 2 is in a range of 5 wt% to 40 wt%, based on the total weight of the acrylate units included in the acrylic polymer.

**16.** The light control film according to claim 13, wherein the ratio of the polyfunctional acrylate unit is in a range of 5 wt% to 80 wt%, based on the total weight of the acrylate units included in the acrylic polymer.

**17.** An organic light-emitting device comprising:

an organic light-emitting panel; and
the light control film of claim 1 disposed on a viewing side of the organic light-emitting panel.

**18.** The organic light-emitting device according to claim 17, further comprising a polarizing layer on the viewing side, wherein the light control film is disposed between the polarizing layer and the organic light-emitting panel, or on the side surface of the polarizing layer opposite to the surface facing the organic light-emitting panel.

**19.** The organic light-emitting device according to claim 18, wherein the first surface of the main body of the light control film is disposed closer to the polarizing layer relative to the second surface,

the distance between the polarizing layer and the first surface is 250 μm or less, and
the difference N1-N2 between the refractive index N1 of the main body and the refractive index N2 of the filling material is in a range of 0.03 to 0.06.

**20.** The organic light-emitting device according to claim 18, wherein the first surface of the main body of the light control film is disposed closer to the polarizing layer relative to the second surface,

the distance between the polarizing layer and the first surface is more than 250 μm, and
the difference N1-N2 between the refractive index N1 of the main body and the refractive index N2 of the filling material is in a range of 0.02 to 0.05.

[Figure 1]

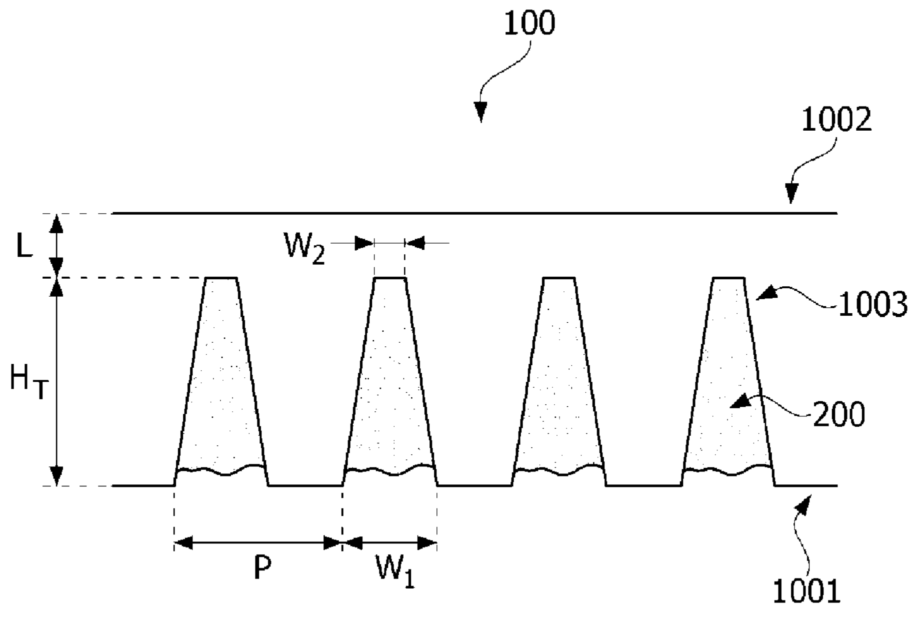

[Figure 2]

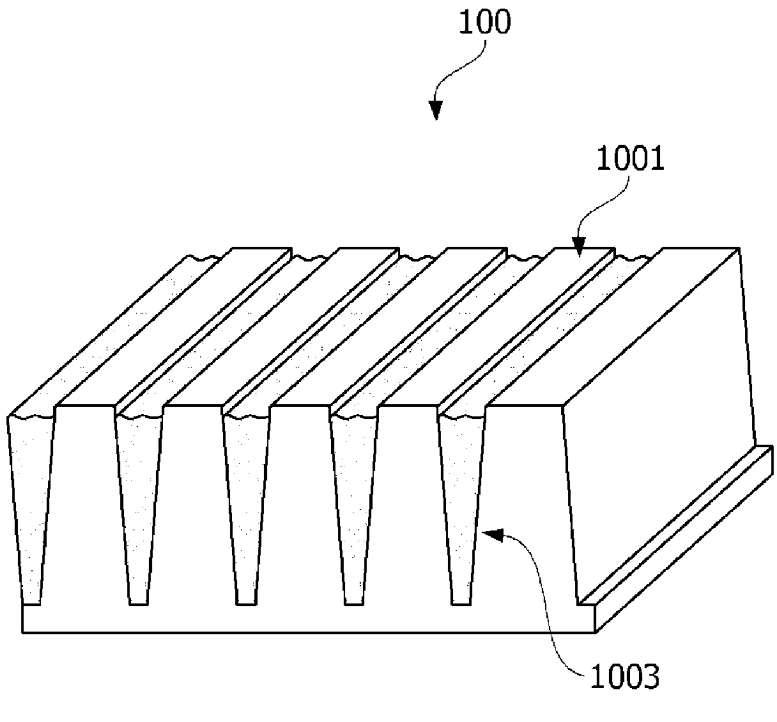

[Figure 3]

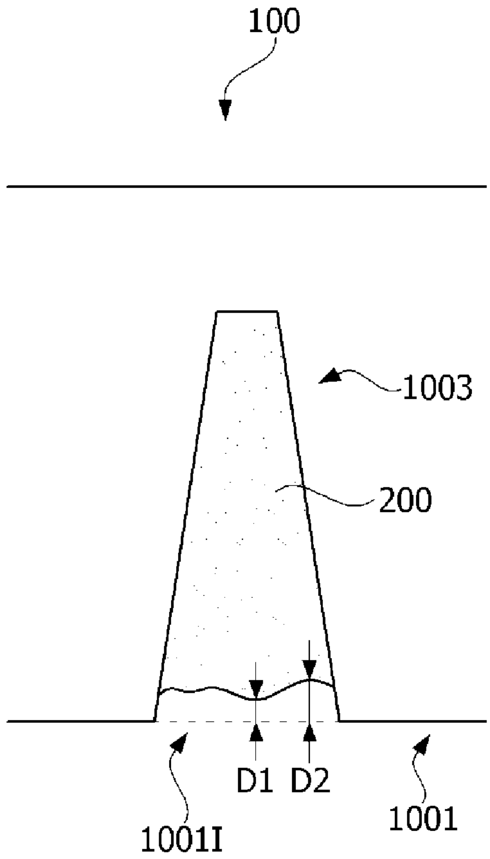

[Figure 4]

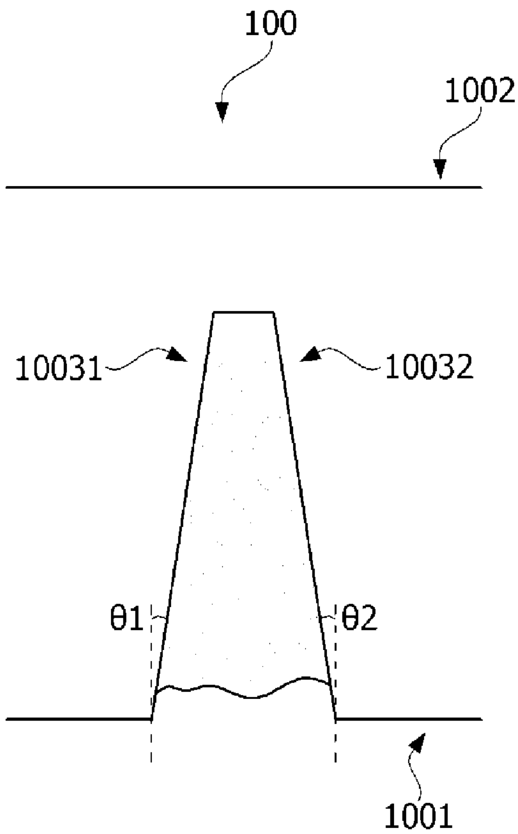

[Figure 5]

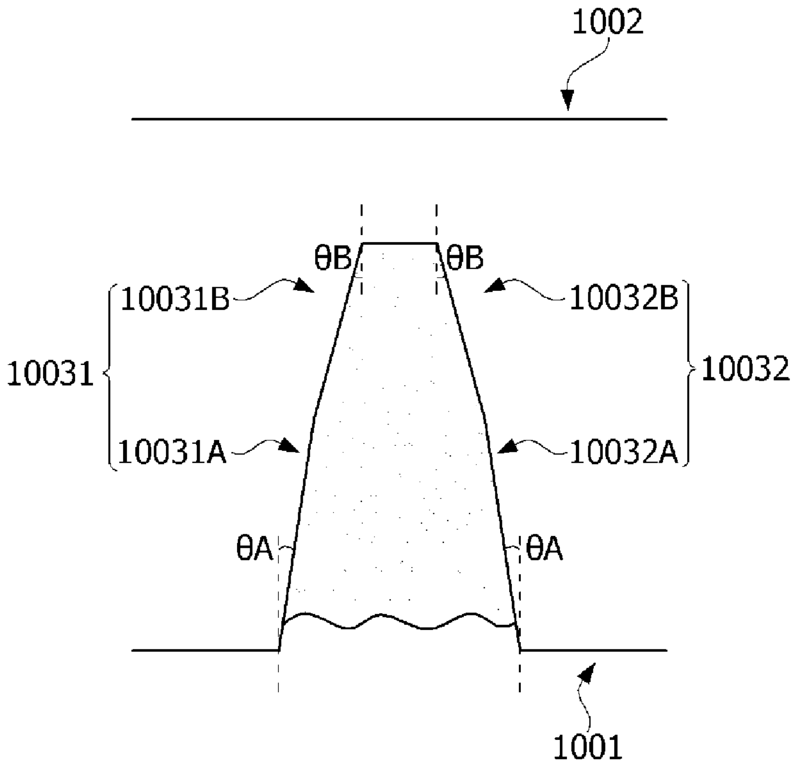
1002
θB
θB
10031B
10032B
10031
10032
10031A
10032A
θA
θA
1001

[Figure 6]

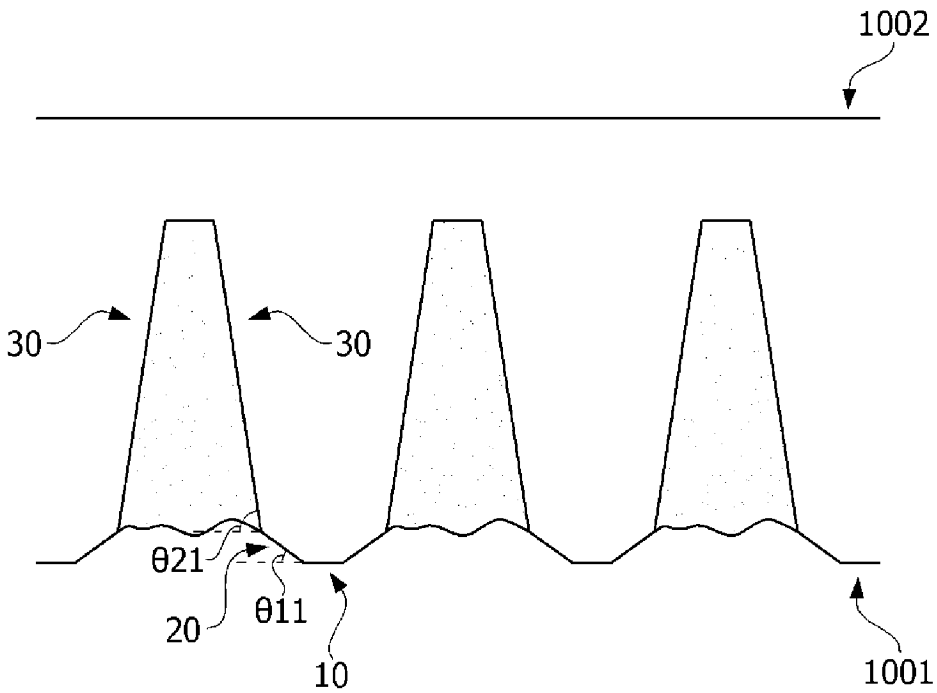

[Figure 7]

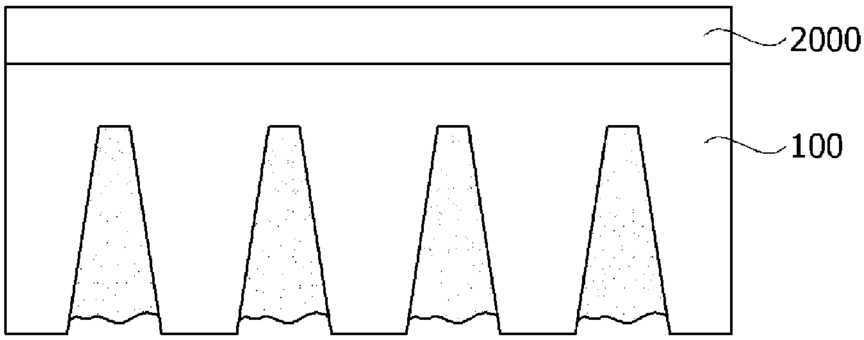

[Figure 8]

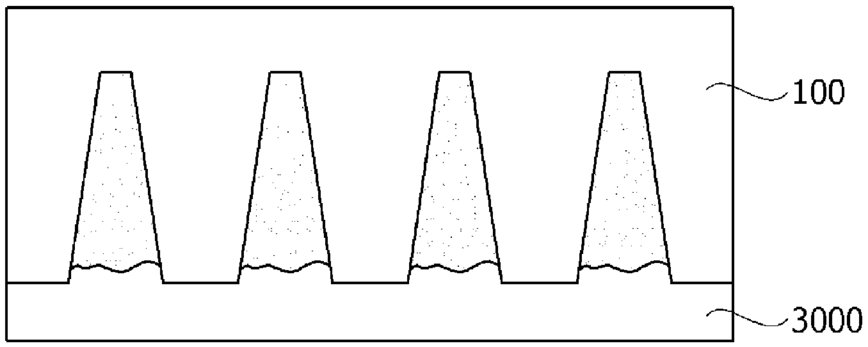

[Figure 9]

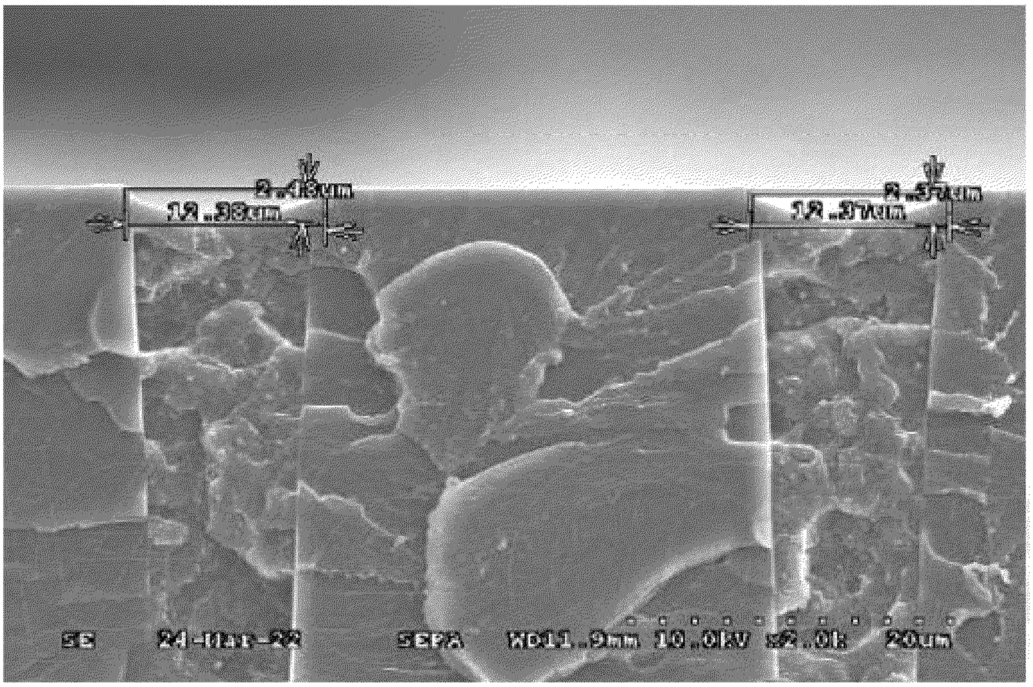

[Figure 10]

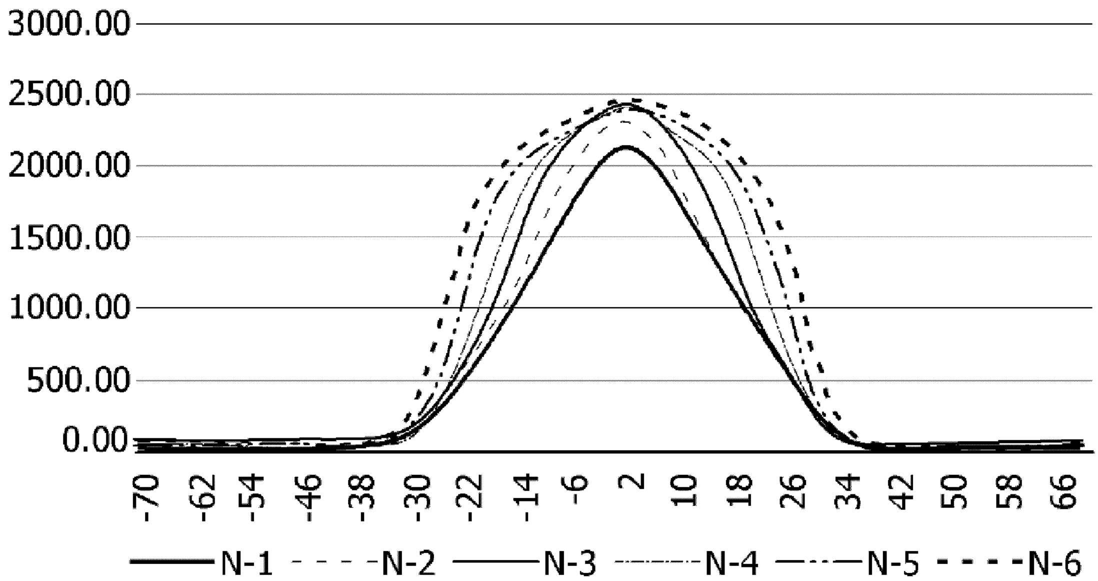
3000.00
2500.00
2000.00
1500.00
1000.00
500.00
0.00
-70
-62
-54
-46
-38
-30
-22
-14
-6
2
10
18
26
34
42
50
58
66
N-1
N-2
N-3
N-4
N-5
N-6

[Figure 11]

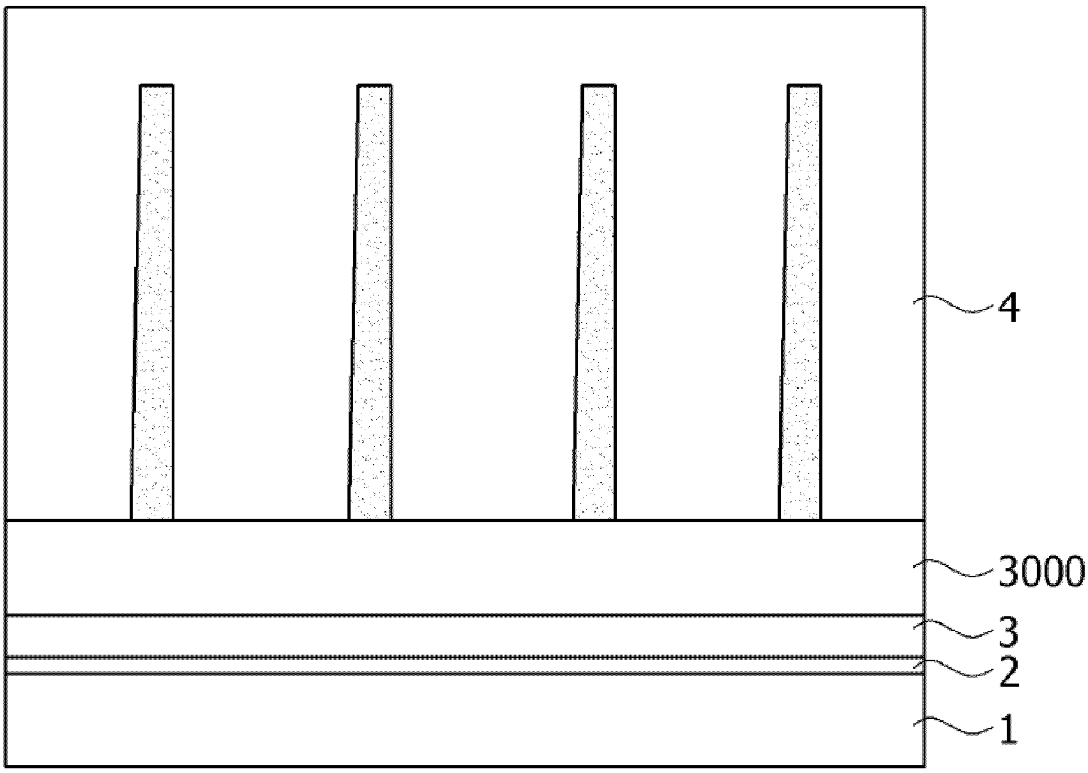

[Figure 12]

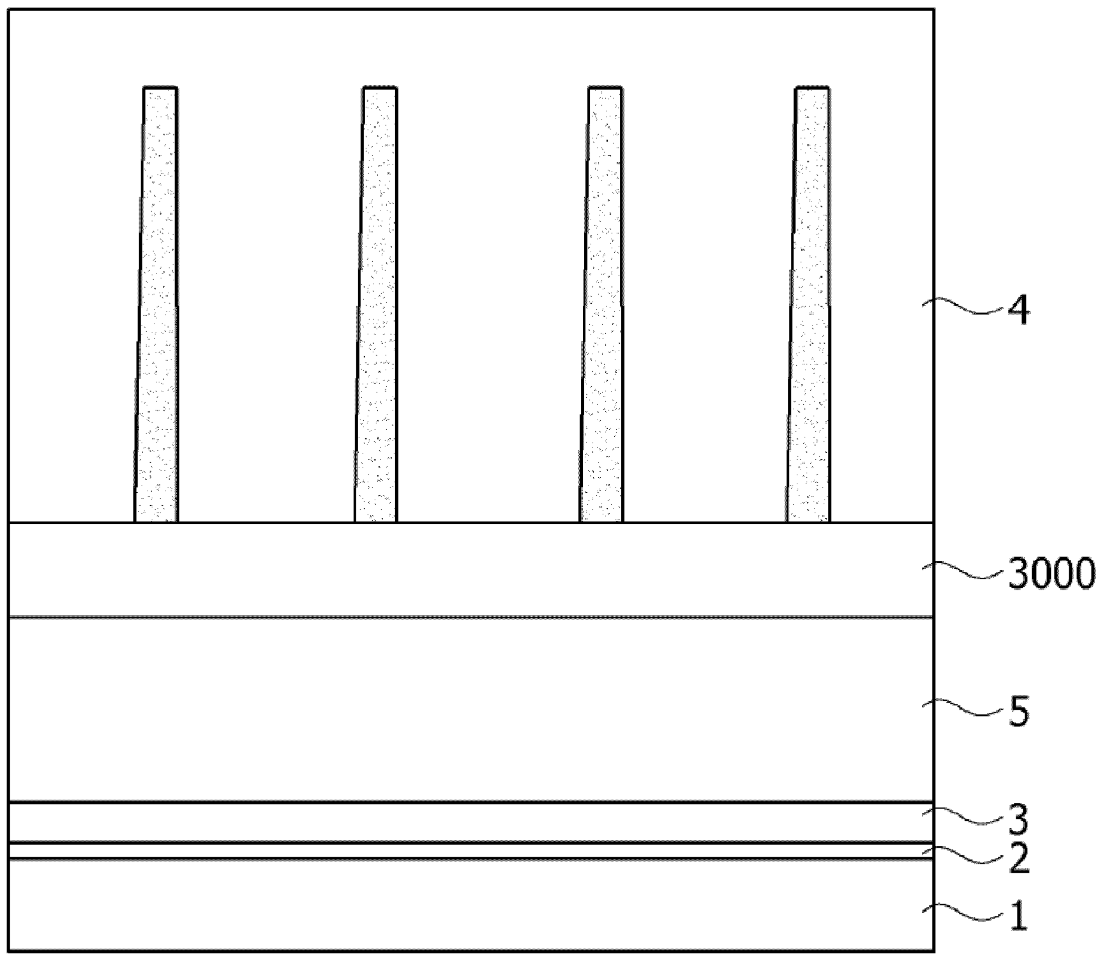

# INTERNATIONAL SEARCH REPORT

International application No.
**PCT/KR2023/021188**

## A. CLASSIFICATION OF SUBJECT MATTER

**H10K 50/86**(2023.01)i; **H10K 50/858**(2023.01)i; **G02B 5/00**(2006.01)i; **G02B 5/22**(2006.01)i

According to International Patent Classification (IPC) or to both national classification and IPC

## B. FIELDS SEARCHED

Minimum documentation searched (classification system followed by classification symbols)

H10K 50/86(2023.01); E06B 5/00(2006.01); G02B 26/00(2006.01); G02B 26/08(2006.01); G02B 5/00(2006.01); G02B 5/04(2006.01); G02B 5/20(2006.01); G02F 1/13357(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 홈(groove), 광 제어(light control), 유기 발광 디바이스(organic electroluminescence device, OLED)

## C. DOCUMENTS CONSIDERED TO BE RELEVANT

| Category* | Citation of document, with indication, where appropriate, of the relevant passages | Relevant to claim No. |
|---|---|---|
| X | JP 2018-132735 A (DAINIPPON PRINTING CO., LTD.) 23 August 2018 (2018-08-23) See claims 2, 8 and 14; paragraphs [0006], [0015]-[0021], [0023], [0024], [0027] and [0036]; and figures 2-4 and 8. | 1-20 |
| X | KR 10-1979273 B1 (LG ELECTRONICS INC.) 16 May 2019 (2019-05-16) See claims 1, 4, 11 and 13; paragraphs [0019], [0021]-[0023] and [0045]; and figures 1-9. | 1,2,10-18 |
| X | KR 10-2022-0163288 A (LMS CO., LTD.) 09 December 2022 (2022-12-09) See claim 1; paragraphs [0032]-[0034]; and figures 1-6. | 1,2,10-18 |
| X | KR 10-2013-0097736 A (3M INNOVATIVE PROPERTIES COMPANY) 03 September 2013 (2013-09-03) See claims 1 and 33; paragraphs [0042], [0043], [0045] and [0046]; and figures 2 and 3. | 1,2,10-18 |
| A | KR 10-2001-0098838 A (KURARAY CO., LTD.) 08 November 2001 (2001-11-08) See entire document. | 1-20 |

☐ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **09 April 2024** | **09 April 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/021188**

| Patent document cited in search report | Publication date (day/month/year) | Patent family member(s) | Publication date (day/month/year) |
|---|---|---|---|
| JP 2018-132735 A | 23 August 2018 | None | |
| KR 10-1979273 B1 | 16 May 2019 | KR 10-2014-0004505 A | 13 January 2014 |
| KR 10-2022-0163288 A | 09 December 2022 | None | |
| KR 10-2013-0097736 A | 03 September 2013 | CN 103052898 A | 17 April 2013 |
| | | CN 103052898 B | 20 January 2016 |
| | | EP 2601546 A2 | 12 June 2013 |
| | | SG 187145 A1 | 28 February 2013 |
| | | TW 201224529 A | 16 June 2012 |
| | | TW I537610 B | 11 June 2016 |
| | | US 2013-0135750 A1 | 30 May 2013 |
| | | US 8659829 B2 | 25 February 2014 |
| | | WO 2012-018705 A2 | 09 February 2012 |
| | | WO 2012-018705 A3 | 24 May 2012 |
| KR 10-2001-0098838 A | 08 November 2001 | JP 2001-356704 A | 26 December 2001 |
| | | JP 2002-042528 A | 08 February 2002 |
| | | JP 4566441 B2 | 20 October 2010 |
| | | KR 10-0806093 B1 | 21 February 2008 |
| | | TW 573111 B | 21 January 2004 |
| | | US 2001-0053074 A1 | 20 December 2001 |
| | | US 6425675 B2 | 30 July 2002 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220180437
- JP 2006171701 A
- WO 2021145469 A1